# EUROPEAN PATENT APPLICATION

(11) **EP 4 797 917 A1**
(43) Date of publication of application: **26.08.2026**
(21) Application number: 25829219.2
(22) Date of filing: 09.01.2025
(51) Int. Cl.: H10K 50/13, H10K 59/122

(54) **DISPLAY PANEL, DISPLAY SCREEN AND ELECTRONIC DEVICE**

(30) Priority: 20.06.2024 CN 202410807734
(71) Applicant: HUAWEI TECHNOLOGIES CO., LTD., Shenzhen 518129 (CN)
(72) Inventor: XU, Zeng, Shenzhen, Guangdong 518129 (CN); YUAN, Jiakun, Shenzhen, Guangdong 518129 (CN)
(74) Representative: Maiwald GmbH
(86) International application number: PCT/CN2025/071564
(87) International publication number: WO 2025/260725

(57) **Abstract**

This application relates to the field of display panel technologies, and discloses a display panel, a display, an electronic device, and a display panel. A CGL of the display panel includes an N-CGL, an i-CGL, and a P-CGL that are sequentially stacked. Corresponding to the i-CGL being made of an organic material, an LUMO energy level of the organic material is lower than or equal to -3.5 eV. Corresponding to the i-CGL being made of an inorganic material, a work function of the inorganic material is higher than or equal to 3.5 eV. Particularly, a Fermi level of the i-CGL is lower than a Fermi level of a host material of the P-CGL, and a thickness of the i-CGL may be any value less than or equal to 15 nm (in particularly, less than 5 nm). In this case, charge generation capabilities of the N-CGL, the i-CGL, and the P-CGL in a direction parallel to a thickness of the CGL are improved. In addition, a sheet resistance in a direction perpendicular to the thickness of the CGL is greater than 1 GΩ/□, so that a subpixel can implement high-efficiency and low-power light-emitting, and a voltage value obtained by a subpixel by dividing a drive voltage of another subpixel is small. This reduces or even eliminates crosstalk between subpixels.

## Description

This application claims priority to Chinese Patent Application No. 202410807734.4, filed with the China National Intellectual Property Administration on June 20, 2024 and entitled "DISPLAY PANEL, DISPLAY, AND ELECTRONIC DEVICE", which is incorporated herein by reference in its entirety.

### TECHNICAL FIELD

This application relates to the field of display panel technologies, and in particular, to a display panel, a display, and an electronic device.

### BACKGROUND

A tandem organic light-emitting diode (tandem organic light-emitting diode, Tandem OLED) is an OLED device structure formed by stacking a plurality of conventional OLED devices in series through a charge generation layer (charge generation layer, CGL). A display panel manufactured by using a tandem OLED technology is characterized by high luminance, low power consumption, and a long service life.

However, due to a high lateral conductive property (for example, conductivity in a direction parallel to a direction in which OLED devices in the display panel are connected in series) of the CGL, lateral light emission crosstalk between subpixels may occur on the tandem OLED display panel (for example, in a pixel, a red subpixel is adjacent to a blue subpixel, and in a scenario in which the pixel needs to emit blue light, when a drive voltage is input to the blue subpixel to drive the blue subpixel to emit the blue light, due to the lateral conductivity of the CGL, the red subpixel may be incorrectly driven to emit weak red light, causing red light to be included in the blue light emitted by the pixel). This leads to problems such as a reduced color gamut, a color offset, and an abnormal picture display on a screen.

### SUMMARY

Embodiments of this application provide a display panel, a display, and an electronic device, to help reduce or even eliminate crosstalk between subpixels on a tandem OLED display panel.

According to a first aspect, a display panel is provided. The display panel includes an anode layer, a plurality of light-emitting layers, a cathode, and a plurality of charge generation layers. The plurality of light-emitting layers and the plurality of charge generation layers are disposed between the anode layer and the cathode, and one charge generation layer is disposed between every two light-emitting layers. The charge generation layer includes an N-type charge generation layer, an insertion layer, and a P-type charge generation layer that are sequentially stacked in a first direction, where the first direction is a direction in which the anode layer points to the cathode. A sheet resistance of the charge generation layer in a direction perpendicular to the first direction is greater than 1 GΩ/□. Corresponding to the insertion layer being made of an organic material, a lowest unoccupied molecular orbital energy level of the organic material is lower than or equal to -3.5 eV. Alternatively, corresponding to the insertion layer being made of an inorganic material, a work function of the inorganic material is higher than or equal to 3.5 eV.

In the display panel, the charge generation layer of a three-layer (the N-type charge generation layer, the insertion layer, and the P-type charge generation layer) structure is used, so that the sheet resistance of the charge generation layer of the display panel in the direction perpendicular to the first direction (for example, any direction or a lateral direction in an X-Y plane below) is greater than 1 GΩ/□. In this way, a voltage value obtained by a light-emitting unit of a subpixel by dividing a drive voltage of another subpixel can be reduced, so that a possibility that the subpixel is incorrectly driven to emit light by the voltage value obtained from the voltage division can be reduced. This helps reduce or even eliminate crosstalk between subpixels on a tandem OLED display panel. In addition, compared with a solution in which crosstalk between subpixels is mitigated by disposing an isolation pillar between the subpixels, this can reduce manufacturing costs of the display panel.

In a possible implementation of the first aspect, a thickness of the insertion layer is less than or equal to 15 nm.

In this implementation, a smaller thickness of the insertion layer indicates a smaller sheet resistance of the insertion layer in the direction perpendicular to the first direction. Therefore, when the thickness of the insertion layer is less than or equal to 15 nm, a voltage value obtained by a light-emitting unit of a subpixel by dividing a drive voltage of another subpixel can be further reduced, so that a possibility that the subpixel is incorrectly driven to emit light by the voltage value obtained from the voltage division can be reduced. This helps reduce or even eliminate crosstalk between subpixels on a tandem OLED display panel.

In a possible implementation of the first aspect, a thickness of the insertion layer is less than or equal to 5 nm.

In this implementation, when the thickness of the insertion layer is less than or equal to 5 nm, the insertion layer may form a discontinuous thin film on a surface perpendicular to the first direction, so that the sheet resistance of the insertion layer in the direction perpendicular to the first direction is greatly reduced. When the thickness of the insertion layer is less than or equal to 5 nm, a voltage value obtained by a light-emitting unit of a subpixel by dividing a drive voltage of another subpixel can be further reduced, so that a possibility that the subpixel is incorrectly driven to emit light by the voltage value obtained from the voltage division can be reduced. This helps reduce or even eliminate crosstalk between subpixels on a tandem OLED display panel.

In a possible implementation of the first aspect, a Fermi level of the insertion layer is lower than a Fermi level of a host material of the P-type charge generation layer.

In this implementation, when the Fermi level of the insertion layer is lower than the Fermi level of the host material of the P-type charge generation layer, an accumulation junction may be formed between the insertion layer and the P-type charge generation layer. This can prevent a drive voltage of the display panel from increasing with as use time increases, and help reduce power consumption of the display panel.

In a possible implementation of the first aspect, a material of the N-type charge generation layer includes a host material and a guest material, and a concentration of the guest material ∈ (0%, 10%].

In this implementation, the insertion layer has a charge generation capability, so that when a same charge generation capability is provided for a light-emitting layer, the concentration of the guest material in the N-type charge generation can be reduced.

In a possible implementation of the first aspect, the display panel further includes a pixel definition layer. The anode layer includes a plurality of anodes, and any two adjacent anodes in the plurality of anodes are isolated by the pixel definition layer. Corresponding to a first anode and a second anode that are adjacent to each other in the plurality of anodes: the first anode has a top surface facing the cathode layer; a portion that is of the pixel definition layer and that is located between the first anode and the second anode has a slope angle; an acute angle formed by the top surface and a connection line between any two points within a surface that is of the cathode and that faces the pixel definition layer is less than or equal to the slope angle; and an acute angle formed by the top surface and a connection line between any two points within a surface that is of the cathode and that is away from the pixel definition layer is less than or equal to the slope angle.

In this implementation, in the display panel that satisfies the above structure, a region between any two anodes is of a flat structure, and a surface of the region is continuous without bulges or grooves. There is no isolation structure at such a pixel definition layer, so that the cathode can be continuous without interruption, a voltage drop on the cathode is reduced, and power consumed by the cathode is reduced. Therefore, the drive voltage and power consumption of the display panel are low, and abnormal pixel lighting can be avoided. In addition, a photomask and a photolithography process required by the isolation structure can be avoided. This can simplify a process and reduce costs. In addition, reliability of the display panel can be improved.

In a possible implementation of the first aspect, the display panel further includes a hole injection layer, an electron injection layer, a plurality of hole transport layers, a plurality of electron transport layers, and a substrate. The hole injection layer and one hole transport layer are sequentially stacked in the first direction between the anode layer and a first light-emitting layer that is in the plurality of light-emitting layers and that is closest to the anode layer. One electron transport layer and the electron injection layer are sequentially stacked in the first direction between the cathode and a second light-emitting layer that is of the plurality of light-emitting layers and that is closest to the cathode. One electron transport layer and one hole transport layer are disposed between every two light-emitting layers, and the electron transport layer, the insertion layer, and the hole transport layer between every two light-emitting layers are sequentially stacked in the first direction. The substrate is disposed on a side that is of the anode layer and that is away from the cathode layer.

In a possible implementation of the first aspect, the display panel further includes a plurality of hole blocking layers, and one hole blocking layer is disposed between each light-emitting layer and an adjacent electron transport layer.

In a possible implementation of the first aspect, the display panel includes a plurality of pixels arranged in an array, each pixel includes four subpixels of different colors, and four subpixels in one pixel are arranged in two rows and two columns. In two adjacent pixels, a color setting manner of subpixels in a first row of one pixel is the same as a color setting manner of subpixels in a second row of the other pixel, and a color setting manner of subpixels in a second row of the pixel is the same as a color setting manner of subpixels in a first row of the other pixel.

In this implementation, in two adjacent pixels in a column, colors of subpixels close to boundaries of the two pixels may be the same. In this way, two subpixels with the same color that are close to the boundaries of the two pixels in the two adjacent pixels in the column can be prepared through an opening in a fine metal mask, thereby helping reduce manufacturing costs of the display panel.

In a possible implementation of the first aspect, the display panel includes a plurality of pixels arranged in an array, each pixel includes four subpixels of different colors, and four subpixels in one pixel are arranged in two rows and two columns. In two adjacent pixels, a color setting manner of subpixels in a first column of one pixel is the same as a color setting manner of subpixels in a second column of the other pixel, and a color setting manner of subpixels in a second column of the pixel is the same as a color setting manner of subpixels in a first column of the other pixel.

In this implementation, in two adjacent pixels in a row, colors of subpixels close to boundaries of the two pixels may be the same. In this way, two subpixels with the same color that are close to the boundaries of the two pixels in the two adjacent pixels in the row can be prepared through an opening in a fine metal mask, thereby helping reduce manufacturing costs of the display panel.

In a possible implementation of the first aspect, the four subpixels of different colors include a red subpixel, a blue subpixel, a green subpixel, and a cerulean subpixel.

In this implementation, a color to be displayed by each pixel of the display panel is obtained by mixing light emitted by the red subpixel, the blue subpixel, the green subpixel, and the cerulean subpixel.

In a possible implementation of the first aspect, each red subpixel includes, at each light-emitting layer, a first auxiliary layer and a red light-emitting unit that are stacked in the first direction; each green subpixel includes, at each light-emitting layer, a second auxiliary layer and a green light-emitting unit that are stacked in the first direction; each blue subpixel includes, at each light-emitting layer, a third auxiliary layer and a blue light-emitting unit that are stacked in the first direction; and each cerulean subpixel includes one cerulean light-emitting unit at each light-emitting layer.

In a possible implementation of the first aspect, the display panel includes two light-emitting layers. Each red subpixel includes, at a light-emitting layer that is in the two light-emitting layers and that is close to the cathode, a first auxiliary layer and a red light-emitting unit that are stacked in the first direction, and includes, at a light-emitting layer that is in the two light-emitting layers and that is close to the anode layer, a red light-emitting unit. Each green subpixel includes, at the light-emitting layer that is in the two light-emitting layers and that is close to the cathode, a second auxiliary layer and a red light-emitting unit that are stacked in the first direction, and includes, at the light-emitting layer that is in the two light-emitting layers and that is close to the anode layer, a red light-emitting unit. Each blue subpixel includes, at the light-emitting layer that is in the two light-emitting layers and that is close to the cathode, a first auxiliary layer and a blue light-emitting unit that are stacked in the first direction, and includes, at the light-emitting layer that is in the two light-emitting layers and that is close to the anode layer, a blue light-emitting unit. Each cerulean subpixel includes one cerulean light-emitting unit at each light-emitting layer.

In a possible implementation of the first aspect, the display panel includes a plurality of pixels arranged in an array, and each pixel includes one red subpixel, one blue subpixel, and one or more green subpixels.

In this implementation, a color to be displayed by each pixel of the display panel is obtained by mixing light emitted by the red subpixel, the blue subpixel, and the green subpixel.

In a possible implementation of the first aspect, a light-emitting unit of each red subpixel at each light-emitting layer is a red light-emitting unit; a light-emitting unit of each green subpixel at each light-emitting layer is a green light-emitting unit; and a light-emitting unit of each blue subpixel at each light-emitting layer is a blue light-emitting unit.

In a possible implementation of the first aspect, the display panel further includes a capping layer and an encapsulation layer that are sequentially stacked from the cathode in the first direction.

In a possible implementation of the first aspect, the display panel further includes a capping layer, an encapsulation layer, a color change layer, and a color filter layer that are sequentially stacked from the cathode in the first direction, and light-emitting units of each red subpixel, each green subpixel, and each blue subpixel at each light-emitting layer are all blue light-emitting units. The red subpixel includes a red change unit at the color change layer, and includes a red filter unit at the color filter layer, where the red change unit is configured to convert light emitted by a blue light-emitting unit corresponding to the red subpixel into red light for emission, and the red filter unit is configured to filter the red light emitted by the red change unit and then emit red light. The green subpixel includes a green change unit at the color change layer, and includes a green filter unit at the color filter layer, where the green change unit is configured to convert light emitted by a blue light-emitting unit corresponding to the green subpixel into green light for emission, and the green filter unit is configured to filter the green light emitted by the green change unit and then emit green light. The blue subpixel includes a blue change unit at the color change layer, and includes a blue filter unit at the color filter layer, where the blue change unit is configured to convert light emitted by a blue light-emitting unit corresponding to the blue subpixel into blue light for emission, and the blue filter unit is configured to filter the blue light emitted by the blue change unit and then emit blue light. Alternatively, the blue subpixel includes a blue filter unit at the color filter layer, and the blue change unit is configured to filter light emitted by a blue light-emitting unit corresponding to the blue subpixel and then emit blue light.

In a possible implementation of the first aspect, the display panel further includes a capping layer, an encapsulation layer, and a color filter layer that are sequentially stacked from the cathode in the first direction, and light-emitting units of each red subpixel, each green subpixel, and each blue subpixel at the plurality of light-emitting layers emit white light as a whole. The red subpixel includes a red filter unit at the color filter layer, and the red filter unit is configured to filter the white light emitted by a light-emitting unit corresponding to the red subpixel and then emit red light. The green subpixel includes a green filter unit at the color filter layer, and the green filter unit is configured to filter the white light emitted by a light-emitting unit corresponding to the green subpixel and then emit green light. The blue subpixel includes a blue filter unit at the color filter layer, and the blue filter unit is configured to filter the white light emitted by a light-emitting unit corresponding to the blue subpixel and then emit blue light.

According to a second aspect, a display is provided. The display includes the display panel provided in any one of the first aspect or the possible implementations of the first aspect.

In a possible implementation of the second aspect, the display further includes a cover plate, and the cover plate is attached to the display panel.

According to a third aspect, an electronic device is provided. The electronic device includes the display provided in any one of the second aspect or the possible implementations of the second aspect.

In a possible implementation of the third aspect, the electronic device further includes a mechanical part, and the display is fastened to the mechanical part.

It should be noted that, for beneficial effects of the second aspect and the third direction, refer to the first aspect. Details are not described herein again.

### BRIEF DESCRIPTION OF DRAWINGS

FIG. 1 is a diagram of a display panel 10 according to some embodiments of this application;
FIG. 2A is a diagram of an equivalent circuit between a blue subpixel B1 and a red subpixel R1 in a pixel P1 according to some embodiments of this application;
FIG. 2B is a diagram of an equivalent circuit between a blue subpixel B1 and a red subpixel R1 when a drive voltage is input only to an anode of the blue subpixel B1 according to some embodiments of this application;
FIG. 3A is a diagram in which an isolation pillar is added between subpixels according to some embodiments of this application;
FIG. 3B is a comparison diagram of isolation pillars when subpixels of a pixel increase according to some embodiments of this application;
FIG. 4 is a diagram of a structure of a display panel according to some embodiments of this application;
FIG. 5A is a diagram of curves of natural logarithms *In*(Rₑ) of internal resistances of different light-emitting devices and natural logarithms *In*(I) of currents of the different light-emitting devices according to some embodiments of this application;
FIG. 5B is a diagram of an equivalent resistance of a light-emitting device according to some embodiments of this application;
FIG. 6A is a diagram of a curve of natural logarithms *In*(Rₑ) of internal resistances of a light-emitting device and natural logarithms *In*(I) of currents of the light-emitting device according to some embodiments of this application;
FIG. 6B is a diagram of a curve in which a current density of a light-emitting unit varies with a drive voltage according to some embodiments of this application;
FIG. 7 is a diagram of curves of voltages and currents of CGLs when thicknesses of i-CGLs are different according to some embodiments of this application;
FIG. 8A is a diagram of curves in which a current density of a light-emitting layer varies with a drive voltage in a display panel using a two-layer CGL and a three-layer CGL according to some embodiments of this application;
FIG. 8B is a diagram of curves in which light-emitting luminance of a light-emitting unit varies with a drive voltage in a display panel using a two-layer CGL and a three-layer CGL according to some embodiments of this application;
FIG. 8C is a diagram of comparison between a current in a two-layer CGL and a current in a three-layer CGL according to some embodiments of this application;
FIG. 9A is a diagram of energy levels of a two-layer CGL according to some embodiments of this application;
FIG. 9B is a diagram of an electric field of a two-layer CGL according to some embodiments of this application;
FIG. 10A is a diagram of energy levels of a three-layer CGL according to some embodiments of this application;
FIG. 10B is a diagram of an electric field of a three-layer CGL according to some embodiments of this application;
FIG. 11A is a diagram of a structure of subpixels of different colors on a display panel 20 according to some embodiments of this application;
FIG. 11B is a diagram of a structure of subpixels of different colors on a display panel 20' according to some embodiments of this application;
FIG. 12A to FIG. 12F are diagrams of a plurality of subpixel arrangement manners according to some embodiments of this application;
FIG. 13A is a diagram of a structure of subpixels of different colors on a display panel 30 according to some embodiments of this application;
FIG. 13B is a diagram of a structure of subpixels of different colors on a display panel 30' according to some embodiments of this application;
FIG. 14A to FIG. 14E are diagrams of a plurality of subpixel arrangement manners according to some embodiments of this application;
FIG. 15A is a diagram of a structure of subpixels of different colors on a display panel 40 according to some embodiments of this application;
FIG. 15B is a diagram of a structure of subpixels of different colors on a display panel 40' according to some embodiments of this application;
FIG. 16A is a diagram of a structure of subpixels of different colors on a display panel 50 according to some embodiments of this application;
FIG. 16B is a diagram of a structure of subpixels of different colors on a display panel 50' according to some embodiments of this application;
FIG. 17 is a diagram of a pixel arrangement and an F-F cross section of a display panel 60 according to some embodiments of this application; and
FIG. 18 is a diagram of a structure of a PDL 30 and a first anode and a second anode that are adjacent to each other in an anode layer according to some embodiments of this application.

### DESCRIPTION OF EMBODIMENTS

For ease of understanding, a basic structure of a tandem OLED display panel (referred to as a display panel below) is first described.

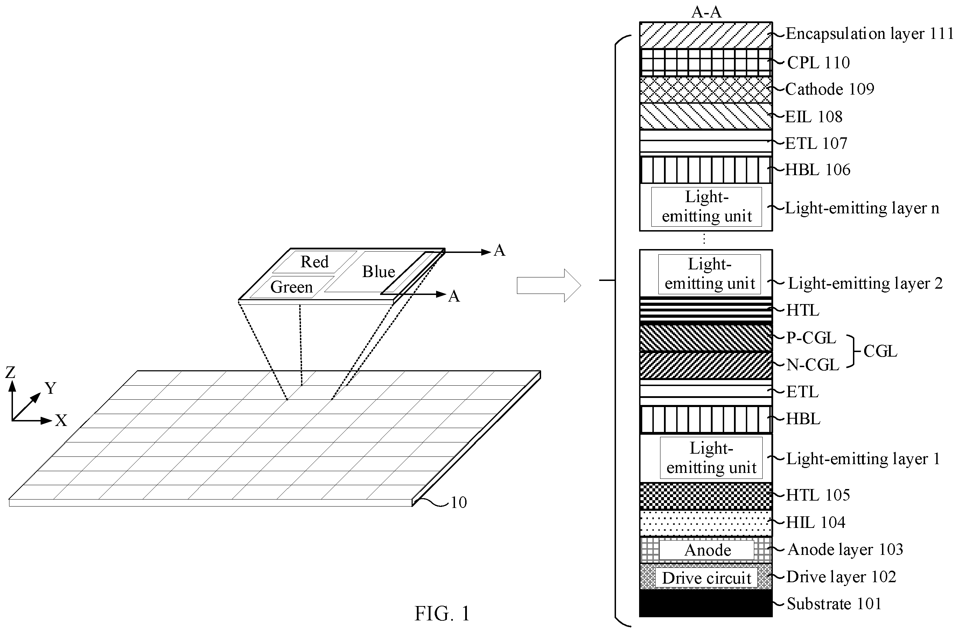

For example, FIG. 1 is a diagram of a display panel 10 according to some embodiments of this application.

As shown in FIG. 1, the display panel 10 includes a plurality of pixels, and each pixel includes a plurality of subpixels, for example, a red (red, R) subpixel, a green (green, G) subpixel, and a blue (blue, B) subpixel. For ease of description, a plane at which the display panel 10 displays a picture is defined as an X-Y plane, a direction perpendicular to the X-Y plane is referred to as a Z direction, and any direction in the X-Y plane may be referred to as a lateral direction.

Still refer to FIG. 1. It can be learned from a partial cross-sectional view of a blue subpixel in a pixel of the display panel 10 on an A-A cross section that the display panel 10 includes a substrate 101 as well as a drive layer 102, an anode 103, a hole injection layer (hole injection layer, HIL) 104, a hole transport layer (hole transport layer, HTL) 105, a light-emitting layer 1 to a light-emitting layer n (n is a positive integer greater than 1), a hole blocking layer (hole blocking layer, HBL) 106, an electron transport layer (electron transport layer, ETL) 107, an electron injection layer (electron injection layer, EIL) 108, a cathode 109, a capping layer (capping layer, CPL) 110, and an encapsulation layer 111 that are sequentially disposed in the Z direction from the substrate 101. An HBL, an ETL, a CGL, and an HTL are sequentially disposed between an i^{th} (1≤i<n) light-emitting layer (the light-emitting layer i) and an (i+1)^{th} light-emitting layer (the light-emitting layer i+1). The CGL includes an N-type charge generation layer (N-Type charge generation layer, N-CGL) disposed on a side that is of the CGL and that is close to the anode 103 and a P-type charge generation layer (P-Type charge generation layer, P-CGL) disposed on a side that is of the CGL and that is close to the cathode 109.

The substrate 101 is configured to support another layer. In some embodiments, the substrate 101 may be a rigid display glass substrate, a flexible display substrate, a monocrystalline silicon substrate, another substrate, or the like. The flexible substrate includes but is not limited to a substrate that can be bent, folded, or arbitrarily changed in shape, such as polyimide (polyimide, PI) or fabric. The silicon substrate includes but is not limited to a monocrystalline silicon wafer.

In some embodiments, the substrate 101 may also be referred to as a base.

The drive layer 102 may include a drive circuit of the display panel 10. The drive circuit is configured to drive the OLED to emit light, and may be a low-temperature polycrystalline silicon (low-temperature polycrystalline silicon, LTPS) drive circuit, a low-temperature polycrystalline oxide (low-temperature polycrystalline oxide, LTPO) drive circuit, an indium gallium zinc oxide (indium gallium zinc oxide, IGZO) drive circuit, a silicon-based complementary metal oxide semiconductor (complementary metal oxide semiconductor, CMOS) drive circuit, or another drive circuit.

The anode layer 103 includes an anode corresponding to each subpixel. In some embodiments, a material of the anode may be a metal oxide, a nitride, a metal, or an alloy. For example, indium tin oxide (ITO), titanium (Ti), silver (Ag), aluminum (Al), titanium nitride (TiN), or an alloy of the foregoing materials. The anode may generate a hole under an external drive voltage, and the hole from the anode moves toward a light-emitting layer driven by the drive voltage applied by the drive layer 102.

In some embodiments, various anodes in the anode layer 103 are separated by a pixel defining layer (pixel defining layer, PDL) (also referred to as a pixel definition layer).

The HIL 104 is a functional layer for injecting a hole into the HTL 105. In some embodiments, a material of the HIL 104 may be a material that reduces a hole injection barrier, for example, an organic material such as an aromatic amino organic compound, an aromatic hydrocarbon organic compound, or an alipcyclic organic compound and an isotope derivative thereof (for example, hexaazatriphenylenehexacarbonitrile (HATCN), copper phthalocyanine (CuPc), or the like); or an inorganic material such as a metal oxide (for example, molybdenum trioxide (MoO₃), vanadium pentoxide (V₂O₅), tungsten oxide (WO₃), or the like), a metal chloride (for example, ferric chloride (FeCl₃) or the like).

The HTL (for example, the HTL 105, the HTL disposed between the light-emitting layers, or the like) is a functional layer configured to transport a hole to an adjacent light-emitting layer. For example, the HTL 105 may transport a hole to the light-emitting layer 1. In some embodiments, a material of the HTL may be an organic material such as an aromatic amino organic compound or an aromatic hydrocarbon organic compound and an isotope derivative thereof (for example, TAPC (4-[1-[4-[bis(4-methylphenyl)amino]phenyl]cyclohexyl]-N-(3-methylphenyl)-N-(4-methylphenyl)aniline), NPB (N,N'-diphenyl-N,N'-(1-naphthyl)-1,1'-biphenyl-4,4'-diamine), or the like).

The light-emitting layers (for example, the light-emitting layer 1 to the light-emitting layer n) are functional layers configured to implement a light-emitting function. Each subpixel has one or more light-emitting units at each light-emitting layer, that is, one subpixel may have at least n light-emitting units respectively disposed at n light-emitting layers. The light-emitting layer includes a host material and a guest material. The host material includes an aromatic amino organic compound, an aromatic hydrocarbon organic compound, and an isotope derivative thereof. The guest material includes materials such as a complex containing Ir or Pt, an aromatic hydrocarbon compound containing boron and an isotope derivative thereof, and the like. For example, the host material is CBP (4,4'-bis(9-carbazolyl)biphenyl), and the guest material is Ir(ppy)₃ (tris(2-phenylpyridine)iridium) or the like.

In some embodiments, one pixel may have a plurality of subpixels. For example, one pixel shown in FIG. 1 includes one blue subpixel, one red subpixel, and one green subpixel. In some other embodiments, one pixel may include another quantity of subpixels, for example, four subpixels (for example, one blue subpixel, one red subpixel, one green subpixel, and one cerulean (cerulean, C) subpixel, or one blue subpixel, one red subpixel, one green subpixel, and one white subpixel, or the like), or five subpixels. This is not limited herein.

In some embodiments, one or more auxiliary layers (also referred to as prime layers) may be further disposed on a side that is of some light-emitting units of the light-emitting layers of the display panel 10 and that is adjacent to the HTL, and are used for microcavity regulation, carrier balance regulation, and blocking electrons and excitons. For a same display panel, quantities of auxiliary layers disposed on light-emitting units of subpixels of different colors may be different. For example, corresponding to a display panel that includes two light-emitting layers, one auxiliary layer may be included between the adjacent HTL and light-emitting units of a red subpixel or a green subpixel at a light-emitting layer 1 and a light-emitting layer 2, and no auxiliary layer is disposed at a light-emitting layer for a blue subpixel. For another example, one auxiliary layer may be included between the adjacent HTL and a light-emitting unit of a red subpixel or a green subpixel at a light-emitting layer 2, and no auxiliary layer is disposed at a light-emitting layer for a blue subpixel.

It should be noted that colors of light emitted by a plurality of light-emitting units corresponding to one subpixel may be the same or different, and may be the same as or different from a color of the subpixel. This is not limited herein. Details are described in the following with reference to a specific structure of the light-emitting layer. Details are not described herein again.

In some embodiments, a material of the auxiliary layer may be an aromatic amino organic compound, an aromatic hydrocarbon organic compound, and an isotope derivative thereof (for example, TCTA (4,4',4''-tris(carbazol-9-yl)triphenylamine) or the like) or the like.

The HBL (for example, the HBL 106, the HBL disposed between the light-emitting layers, or the like) is a functional layer configured to block a hole from being transported to an adjacent functional layer. For example, the HBL 106 may prevent a hole from being transported from the light-emitting layer n to the ETL 107, and prevent a hole from being transported from the ETL 107 to the light-emitting layer n. In some embodiments, a material of the HBL may be an organic aromatic material, for example, an organic material containing a group such as pyridine, pyrazine, pyrimidine, triazine, imidazole, phenyl, naphthyl, anthryl, phenanthryl, pyrenyl, or the like, or an organic material substituted with an isotope such as deuterium, tritium, or N¹⁵ for the aforementioned groups, for example, an organic material such as BCP (2,9-dimethyl-4,7-diphenyl-1,10-phenanthroline), B4PyMPM (4,6-bis(3,5-di(4-pyridyl)phenyl)-2-methylpyrimidine), and BmPyPB (1,3-bis(3,5-di(pyridin-3-yl)phenyl)benzene).

In some embodiments, the HBL is optional.

The ETL (for example, the ETL 107, the ETL disposed between the light-emitting layers, or the like) is a functional layer configured to transport electrons. For example, the ETL 107 may transport electrons injected by the EIL 108 to the light-emitting layer n through the HBL 106. In some embodiments, a material of the ETL may be an organic aromatic material, for example, an organic material containing a group such as pyridine, pyrazine, pyrimidine, triazine, imidazole, phenyl, naphthyl, anthryl, phenanthryl, pyrenyl, or the like, or an organic material substituted with an isotope such as deuterium, tritium, or N¹⁵ for the aforementioned groups, for example, an organic material such as TmPyPB (1,3,5-tris(3-pyridin-3-ylphenyl)benzene), Bphen (4,7-diphenyl-1,10-phenanthroline), or TPBi (1,3,5-tris(1-phenyl-1H-benzimidazol-2-yl)benzene), or a metal complex material such as lithium 8-hydroxyquinolinate (LiQ).

The EIL 108 is a functional layer configured to inject electrons. For example, the EIL 108 may inject electrons from the cathode into the ETL 107. In some embodiments, a material of the EIL 108 may be an organic material such as lithium 8-hydroxyquinolinate (LiQ), or an inorganic substance such as ytterbium (Yb), lithium (Li), lithium fluoride (LiF), lithium 8-hydroxyquinolinate (LiQ), calcium (Ca), cesium (Cs), lithium oxide (Li₂O), lithium carbonate (Li₂CO₃), lithium nitride (Li₃N), cesium carbonate (Cs₂CO₃), cesium oxide (Cs₂O), or the like.

The cathode 109 is configured to provide a cathode for the display panel 10. In some embodiments, a material of the cathode may be a metal or an alloy, for example, a metal material such as silver (Ag), magnesium (Mg), aluminum (Al), or gold (Au), and an alloy of metals such as Ag, Mg, Al, and Au.

The CPL 110 is configured to improve light extraction efficiency of the display panel 10. In some embodiments, a material of the CPL 110 may be an organic material or an inorganic material, such as LiF or LiQ. In some embodiments, there may be no CPL 110.

The encapsulation layer 111 is a functional layer configured to isolate water and oxygen erosion. The encapsulation layer 111 may be flexible display encapsulation, for example, one or more of chemical vapor deposition (chemical vapor deposition, CVD), thin film encapsulation (thin film encapsulation, TFE), and atomic layer deposition (atomic layer deposition, ALD), or may be rigid display encapsulation, for example, glass cement (Frit), glass cover plate encapsulation, or the like.

The CGL is configured to generate charges, such as electrons and holes, under an external drive voltage. For example, holes and electrons may be generated at an interface between the N-CGL and the P-CGL under the external drive voltage.

The N-CGL is configured to transfer electrons at the interface between the N-CGL and the P-CGL to an adjacent electron transport layer. In some embodiments, the N-CGL may be mainly obtained by doping a host material and a guest material. The host material may be an organic aromatic material, for example, an organic material containing a group such as pyridine, pyrazine, pyrimidine, triazine, imidazole, phenyl, naphthyl, anthryl, phenanthryl, pyrenyl, or the like, or an organic material substituted with an isotope such as deuterium, tritium, or N¹⁵ for the aforementioned groups, for example, an organic material such as TmPyPB (1,3,5-tris(3-pyridin-3-ylphenyl)benzene), Bphen (4,7-diphenyl-1,10-phenanthroline), or TPBi (1,3,5-tris(1-phenyl-1H-benzimidazol-2-yl)benzene). The guest material may include a metal material such as ytterbium (Yb), lithium (Li), samarium (Sm), barium (Ba), cesium (Cs), or calcium (Ca); or may include a metal oxide material such as lithium oxide (Li₂O), lithium carbonate (Li₂CO₃), cesium oxide (Cs₂O), or cesium carbonate (Cs₂CO₃); or may include an organic material or an organometallic complex material such as Liq (lithium 8-hydroxyquinolinolate) or Libpp (lithium 2-(2',2''-bipyridin-6'-yl)phenolate).

The P-CGL is configured to transport a hole at an interface between the N-CGL and the P-CGL to an adjacent hole transport layer. In some embodiments, the P-CGL may be mainly obtained by doping a host material and a guest material. The host material includes an organic aromatic material (such as an organic material containing a group such as primary amino, secondary amino, tertiary amino, quaternary ammonium, phenyl, naphthyl, anthryl, phenanthryl, pyrenyl, fluorenyl, spirofluorenyl, or the like), or an organic material substituted with an isotope such as deuterium, tritium, or N¹⁵ for the aforementioned groups (for example, an organic material such as TAPC (4-[1-[4-[bis(4-methylphenyl)amino]phenyl]cyclohexyl]-N-(3-methylphenyl)-N-(4-methylphenyl)aniline), NPB (N,N'-diphenyl-N,N'-(1-naphthyl)-1,1'-biphenyl-4,4'-diamine), TCTA (4,4',4''-tris(carbazol-9-yl)triphenylamine), or the like). The guest material may include an organic material with a deep lowest unoccupied molecular orbital (lowest unoccupied molecular orbital, LUMO) energy level, such as NDP-9 (4-({2,3-bis[cyano(4-cyano-2,3,5,6-tetrafluorophenyl)methylidene]cyclopropylidene}(cyano)methyl)-2,3,5,6-tetrafluorobenzene-1-carbonitrile), HAT-CN (2,3,6,7,10,11-hexacyano-1,4,5,8,9,12-hexaazatriphenylene), F4-TCNQ (tetrafluoro-tetracyanoquinodimethane), or another organic material; or an inorganic material such as indium tin oxide (ITO), molybdenum trioxide (MoO₃), vanadium pentoxide (V₂O₅), ferric chloride (FeCl₃), tungsten trioxide (WO₃), or rhenium trioxide (ReO₃).

It should be noted that the structure of the display panel 10 shown in FIG. 1 is merely an example. In some other embodiments, the display panel 10 may further include more layers, for example, a color change layer (color change layer, CCL), a color filter (color filter, CF) (or a color filter film), and the like that are stacked on the encapsulation layer 111. This is not limited herein.

With reference to the structure of the display panel 10 shown in FIG. 1, the following describes the technical solutions of this application by using an example in which the display panel 10 includes two light-emitting layers.

As described in the Background, due to a high lateral conductive property (that is, conductivity in the X-Y plane in the case shown in FIG. 1) of the CGL, when a subpixel is driven to emit light, a current flows to a light-emitting unit of another subpixel through the CGL, so that the another subpixel emits light incorrectly. Consequently, light emission crosstalk between subpixels occurs on the display panel.

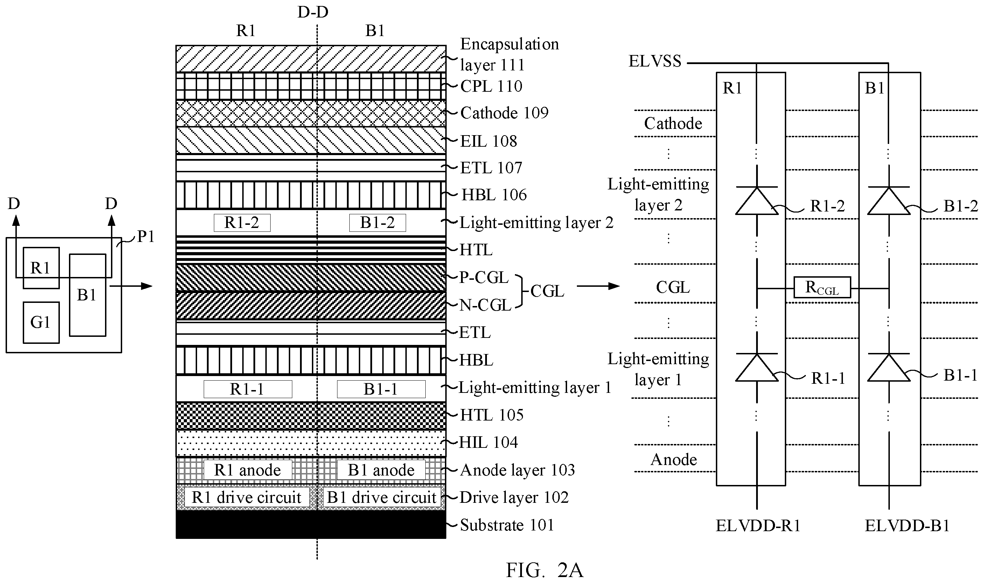

For example, FIG. 2A is a diagram of an equivalent circuit between a blue subpixel B1 and a red subpixel R1 in a pixel P1 according to some embodiments of this application.

As shown in FIG. 2A, based on a partial cross-sectional view of the blue subpixel B1 and the red subpixel R1 in the pixel P1 in a D-D cross section, it can be learned that the drive layer 102 includes an R1 drive circuit corresponding to the red subpixel R1 and a B1 drive circuit corresponding to the blue subpixel B1. The anode layer 103 includes an R1 anode corresponding to the red subpixel R1 and a B1 anode corresponding to the blue subpixel B1. The light-emitting layer 1 includes a light-emitting unit R1-1 corresponding to the red subpixel R1 and a light-emitting unit 1-1 corresponding to the blue subpixel B1. The light-emitting layer 2 includes a light-emitting unit R1-2 corresponding to the red subpixel R1 and a light-emitting unit B1-2 corresponding to the blue subpixel B1. The cathode 109 is connected to a negative voltage ELVSS. When driving the blue subpixel B1 to emit light, the display panel 10 may input a forward voltage ELVDD-B1 to the B1 anode, so that the light-emitting unit B1-1 and the light-emitting unit B1-2 emit light.

Still refer to FIG. 2A. The circuit of the blue subpixel B1 and the red subpixel R1 may be simplified as a connection circuit of an equivalent resistor R_{CGL} of the light-emitting unit R1-1, the light-emitting unit R1-2, the light-emitting unit R1-1, the light-emitting unit R1-2, and the CGL. A positive electrode of the light-emitting unit R1-1 is configured to receive a forward drive voltage ELVDD-R1 of the red subpixel R1, and a negative electrode of the light-emitting unit R1-1 is connected to a positive electrode of the light-emitting unit R1-2 and one end of the equivalent resistor R_{CGL} of the CGL. A positive electrode of the light-emitting unit B1-1 is configured to receive a forward drive voltage ELVDD-B1 of the blue subpixel B1, and a negative electrode of the light-emitting unit B1-1 is connected to a positive electrode of the light-emitting unit B1-2 and the other end of the equivalent resistor R_{CGL} of the CGL. A negative electrode of the light-emitting unit R1-2 and a negative electrode of the light-emitting unit B1-2 are connected to the negative voltage ELVSS. The display panel 10 may input the forward drive voltage ELVDD-R1 to the R1 anode through the R1 drive circuit, to drive the light-emitting unit R1-1 and the light-emitting unit R1-2 to emit light, so that the red subpixel R1 emits red light; or input the forward drive voltage ELVDD-B1 to the B1 anode through the B1 drive circuit, to drive the light-emitting unit B1-1 and the light-emitting unit B1-2 to emit light, so that the blue subpixel B1 emits blue light; or input a forward drive voltage to both the R1 anode and the R2 anode, so that the red subpixel R1 and the blue subpixel B1 emit light.

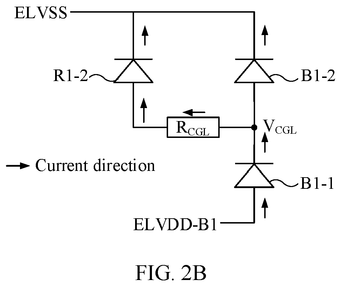

Based on the simplified circuit shown in FIG. 2A, an equivalent circuit when only the blue subpixel B1 in the pixel P1 is driven to emit light is shown in FIG. 2B. It is assumed that in a case in which the light-emitting unit B1-1 and the light-emitting unit B1-2 are driven to emit blue light, a voltage that is of the light-emitting unit B1-1 and the light-emitting unit B1-2 and that is at a junction of the CGL is V_{CGL}. The light-emitting unit R1-2 (the equivalent resistor is denoted as R_{R1-2}) and the resistor R_{CGL} are connected in series, so that a voltage at two ends of the light-emitting unit R1-2 is R_{R1-2}/(R_{R1-2}+R_{CGL})×(V_{CGL}-ELVSS). If R_{R1-2}/(R_{R1-2}+R_{CGL})×(V_{CGL}-ELVSS) is greater than a light-emitting voltage of the light-emitting unit R1-2, the light-emitting unit R1-2 emits red light. As a result, an actual color of light emitted by the pixel P1 is a color obtained by mixing light emitted by the light-emitting unit R1-2, the light-emitting unit B1-1, and the light-emitting unit B1-2, which is different from an expected blue color.

It should be noted that, for crosstalk between other subpixels of a same pixel, or an equivalent circuit between subpixels of different pixels, and a case in which crosstalk occurs, refer to the case in which the crosstalk occurs between the red subpixel R1 and the blue subpixel B1 shown in FIG. 2A and FIG. 2B. Details are not described herein again.

To avoid problems such as a reduced color gamut, a color offset, and an abnormal picture display of the display panel caused by crosstalk between different subpixels, in some embodiments, an isolation pillar may be added between different subpixels, to block a lateral transmission path of a current on the CGL. This can prevent another subpixel from being incorrectly driven to emit light due to lateral conductivity of the CGL when one subpixel is driven to emit light.

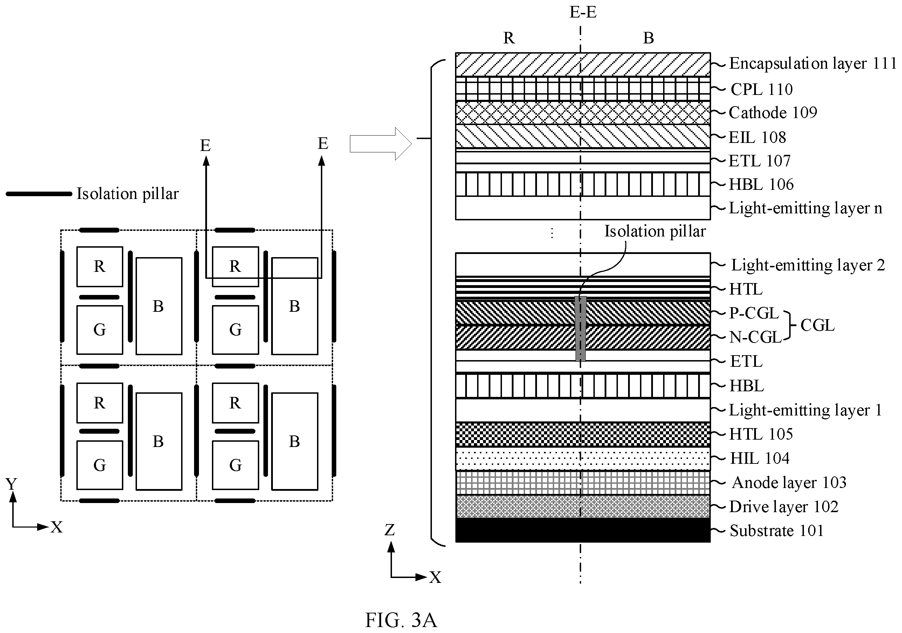

For example, FIG. 3A is a diagram in which an isolation pillar is added between subpixels according to some embodiments of this application.

As shown in FIG. 3A, with reference to a partial cross-sectional view of the red subpixel R1 and the blue subpixel B1 along a section line E-E, isolation pillars may be added to the CGL to block a current propagation path of the red subpixel R1 and the blue subpixel B1 in the CGL. In this way, corresponding to the equivalent circuit shown in FIG. 3A, R_{CGL} is equivalent to an open circuit, so that the two ends of the light-emitting unit R1-2 do not have a division voltage obtained from the drive voltage of the blue subpixel B1, thereby preventing the light-emitting unit R1-2 from emitting light.

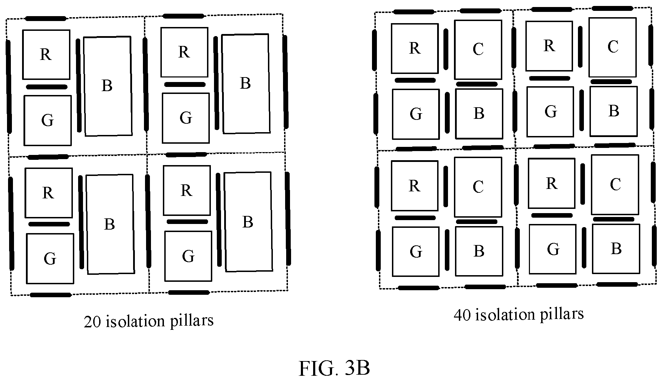

However, adding the isolation pillars to the CGL requires additional process steps such as a photoetching mask and photoetching, that is, an additional process needs to be introduced to add the isolation pillars, resulting in an increase in manufacturing costs of the display panel. In addition, as a quantity of subpixels in a single pixel increases, a quantity of isolation pillars that need to be added increases greatly, resulting in an increase in design difficulty and manufacturing cost of adding the isolation pillars to the CGL. For example, refer to FIG. 3B. When the quantity of subpixels in the single pixel is increased from 3 to 4, the quantity of isolation pillars in a local region is increased from 20 to 40, greatly increasing design difficulty and manufacturing costs of the isolation pillars. In addition, the display panel with the added isolation pillars has a reliability issue. After the display panel faces a scenario like bending, long-time highlighting, or extrusion, performance of the display panel is likely to deteriorate due to a failure of the isolation pillars, for example, the display panel may have defects such as dark spots, shading, and abnormal light-emitting of pixels.

In view of this, an embodiment of this application provides a display panel. In the display panel, a CGL structure different from that in the display panel 10 is used, so that a lateral sheet resistance of the CGL increases (equivalent to increasing the value of R_{CGL} in the equivalent circuits shown in FIG. 2A and FIG. 2B), thereby reducing a lateral conductive capability of the CGL. In this way, when the sheet resistance of the CGL is large enough, it can be ensured that when a subpixel emits light, a voltage value obtained by a light-emitting unit of a subpixel adjacent to the subpixel by dividing a drive voltage of the subpixel is less than a light-emitting voltage of the light-emitting unit of the adjacent subpixel, and the light-emitting unit of the subpixel adjacent to the subpixel does not emit light, so that lateral crosstalk between subpixels may be avoided.

For example, in the case shown in FIG. 2B, it is assumed that a light-emitting voltage of the light-emitting unit R1-2 is V_{o-R}. If the value of R_{CGL} is greater than (V_{CGL}-ELVSS-V_{O-R})×R_{R1-2}/V_{O-R}, when the blue subpixel B1 emits light, a voltage value R_{R1-2}/(R_{R1-2}+R_{CGL})×(V_{CGL}-ELVSS) obtained by the light-emitting unit R1-2 by dividing the drive voltage of the blue subpixel B1 is less than V_{o-R}, and the light-emitting unit R1-2 does not emit light, so that crosstalk is avoided.

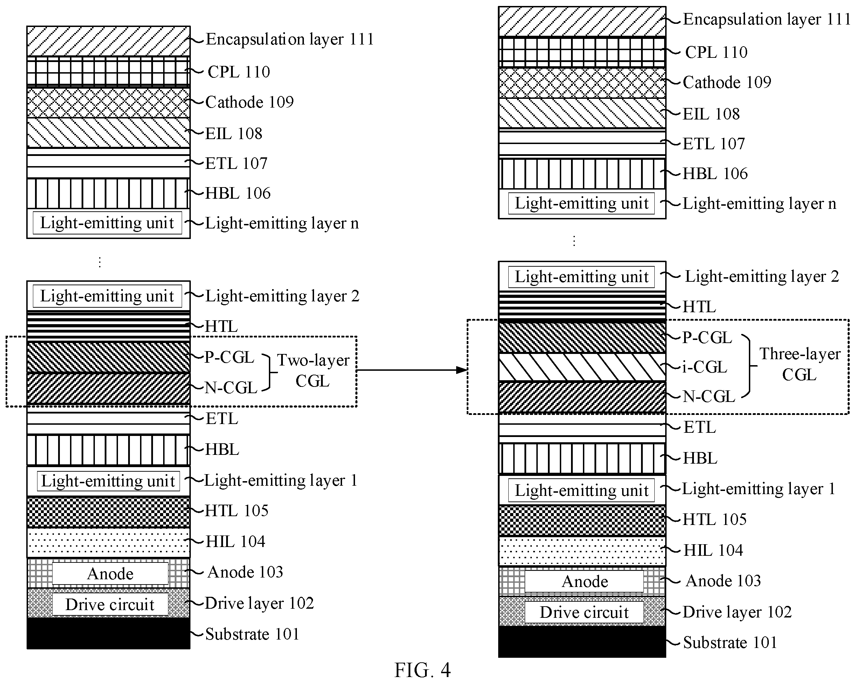

Specifically, refer to FIG. 4. Compared with the CGL in the display panel 10, in the CGL of the display panel, an insertion layer (referred to as an i-CGL below) is added between the N-CGL and the P-CGL. In other words, the CGL includes the N-CGL, the i-CGL, and the P-CGL that are sequentially stacked in the Z direction. The i-CGL may be made of an organic material or an inorganic material. Corresponding to the i-CGL being made of the organic material, an LUMO energy level of the organic material is lower than or equal to -3.5 eV. Corresponding to the i-CGL being made of the inorganic material, a work function of the inorganic material is higher than or equal to 3.5 eV.

In some embodiments, a thickness of the i-CGL may be any value less than 15 nm. In this case, a sheet resistance of the i-CGL in a direction perpendicular to the thickness of the i-CGL (that is, the aforementioned lateral direction or any direction in the X-Y plane) is greater than 1 GΩ/□.

In some embodiments, a material of the i-CGL may be HATCN, CuPC, or the like. It should be noted that, in some other embodiments, the material of the i-CGL may alternatively be another material that satisfies the LUMO energy level being lower than -3.5 eV or the work function being higher than 3.5 eV. This is not limited herein.

In this way, the sheet resistance of the i-CGL in the direction perpendicular to the thickness of the i-CGL (that is, the aforementioned lateral direction or any direction in the X-Y plane) may be greater than 1 GΩ/□. This reduces a voltage value obtained by a light-emitting unit of a subpixel by dividing a drive voltage of another subpixel, and prevents the light-emitting unit of the subpixel from incorrectly emitting light because the voltage value obtained by dividing the drive voltage of the another pixel is higher than a light-emitting voltage.

In some embodiments, a doping concentration of a guest material in the N-CGL may be less than or equal to 100%, for example, 0% to 10%, and may be 0.5% to 3% for example.

In some embodiments, a thickness of the N-CGL is any value less than or equal to 40 nm, and may be any value from 5 nm to 15 nm for example.

In some embodiments, a doping concentration of a guest material in the P-CGL may be less than or equal to 100%, for example, 0% to 20%, and may be 1% for example.

In some embodiments, mobility of the i-CGL is greater than or equal to 10⁻⁶ cm²V⁻¹s⁻¹.

For ease of description, the CGL shown in FIG. 4 that includes the N-CGL, the i-CGL, and the P-CGL that are sequentially stacked in the Z direction is referred to as a three-layer CGL, and the CGL shown in FIG. 1 that includes the N-CGL and the P-CGL that are sequentially stacked in the Z direction is referred to as a two-layer CGL.

In some embodiments, the i-CGL may be used to generate charges, such as electrons and holes. Therefore, when the CGLs achieve a same charge generation capability, compared with the two-layer CGL, in the three-layer CGL, charge generation capabilities that the N-CGL and the P-CGL need to provide are lower than charge generation capabilities that the N-CGL and the P-CGL in the two-layer CGL need to provide. The charge generation capabilities of the N-CGL and the P-CGL are positively correlated with a doping concentration of a guest material. Therefore, the doping concentration of the guest material in the N-CGL and the P-CGL in the three-layer CGL may be lower than the doping concentration of the guest material in the N-CGL and the P-CGL in the three-layer CGL.

In some embodiments, a molecular diameter of an organic material with a LUMO energy level lower than -3.5 eV is usually less than 5 nm, and a diameter of an atom of an inorganic material with a work function higher than 3.5 eV is usually 0 angstroms (Å) to 4 Å. When the thickness of the i-CGL is less than or equal to 5 nm, the i-CGL forms a discontinuous thin film in the lateral direction (for example, in the XY plane in FIG. 1) of the display panel, thereby further increasing the sheet resistance of the i-CGL. In this way, the voltage value obtained by the light-emitting unit of the subpixel by dividing the drive voltage of the another subpixel may be further reduced, to prevent the light-emitting unit of the subpixel from incorrectly emitting light because the voltage value obtained by dividing the drive voltage of the another pixel is high.

The following describes, based on the equivalent circuit shown in FIG. 2B, a principle of reducing pixel crosstalk by adding a transverse resistance in the i-GCL.

Usually, an internal resistance of a light-emitting unit may be calculated by using Formula (1): ${R}_{e} = {e}^{δ} / {I}^{α}$

In Formula (1), Rₑ is the internal resistance of the light-emitting unit, I is a current of the light-emitting unit, e is a natural base, δ is a constant (because e^{δ} is strongly correlated with an energy gap of the light-emitting unit, δ is also referred to as an energy gap constant), and α is a defect factor (correlated with a process of the light-emitting unit, where fewer defects in a film layer of the light-emitting unit indicate that a model of the light-emitting unit is closer to an ideal model, and α is closer to 1). Based on this, the following Formula (2) that is equivalent to Formula (1) may be obtained by taking a natural logarithm of the foregoing Formula (1): $In \left({R}_{e}\right) = In \left({e}^{δ}\right) / In \left({I}^{α}\right) = - αIn \left(I\right) + δ$

In Formula (2), *In* indicates taking the natural logarithm.

It can be learned from Formula (2) that, for a light-emitting unit, a natural logarithm *In*(Rₑ) of an internal resistance of the light-emitting unit is in a linear relationship with a natural logarithm *In*(I) of a current of the light-emitting unit. In other words, the natural logarithm of the internal resistance decreases as the natural logarithm of the current increases.

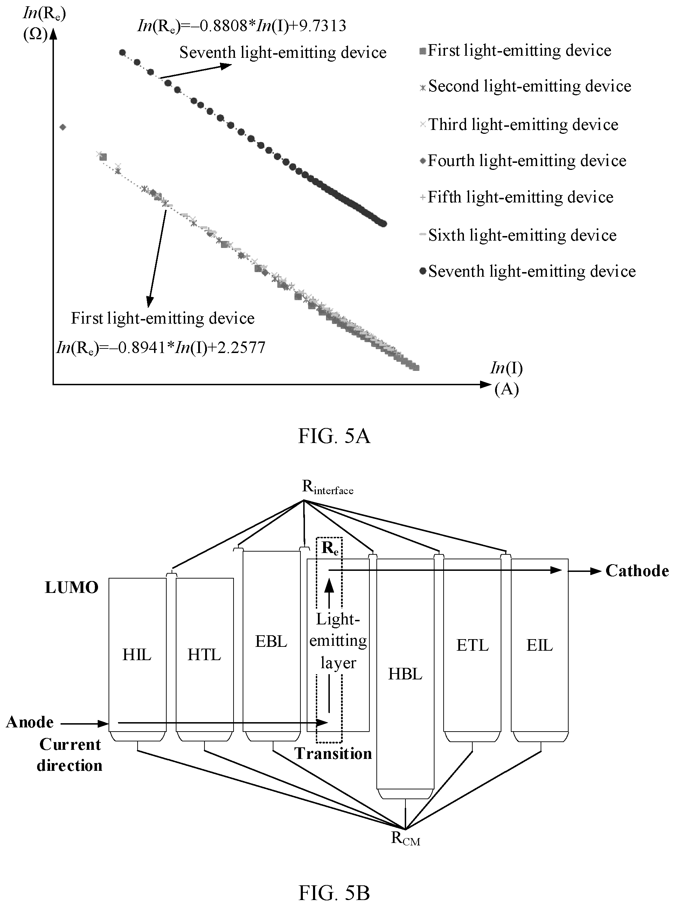

For example, FIG. 5A is a diagram of curves of natural logarithms *In*(Rₑ) of internal resistances of various light-emitting devices and natural logarithms *In*(I) of currents of the various light-emitting devices according to some embodiments of this application.

In FIG. 5A, a horizontal axis represents the natural logarithms *In*(I) of the currents of the light-emitting devices, and a vertical axis represents the natural logarithms *In*(Rₑ) of the internal resistances of the light-emitting devices.

A first light-emitting device is a single organic light-emitting diode (single organic light-emitting diode, single OLED), and has a structure of ITO/HAT-CN (5 nm)/TAPC (40 nm)/TCTA (5 nm)/3TPA-CN (20 nm)/TmPyPB (40 nm)/LiF (1 nm)/Al (120 nm) (for details, refer to the reference document Adv. Optical Mater. 2019, 1801539).

A second light-emitting device is a near-infrared organic light-emitting diode (near-infrared organic light-emitting diode, NIR OLED), and has a structure of ITO/HATCN (5 nm)/TAPC (50 nm)/TCTA (5 nm)/Alq3: 60 wt% DTPS-PT (20 nm)/Bphen (55 nm)/Liq (2 nm)/Al (120 nm). The reference document is Chem. Mater. 2019, 31, 17, 6499-6505.

A third light-emitting device is a perovskite light-emitting diode (perovskite light-emitting diode, PeLED), and has a structure of ITO/NiOx/PTAA/PVK/perovskite light-emitting layer/TPBi/LiF/Al, where the perovskite light-emitting layer is two-dimensional CsPbBr3/Cs4PbBr6 (for details, refer to the reference document J. Mater. Chem. C, 2021, 9, 916-924).

A fourth light-emitting device is a polymer light-emitting diode (polymer light-emitting diode, PLED), and has a structure of ITO/HATCN (5 nm)/TAPC (50 nm)/TCTA (5 nm)/TPB-AC (8 nm)/TPB-AC: 5 wt% Ir (ppy) 2 (acac) (3 nm)/TPB-AC: 3 wt% Ir-(tptpy) 2 (acac) (2 nm)/TPB-AC: 3 wt% Ir (dmdpprdmp) 2 (divm) (9 nm)/BmPyPB (40 nm)/LiF (1 nm)/Al (120 nm) (for details, refer to the reference document ACS Photonics 2019, 6, 767-778).

A fifth light-emitting device is a solution-processed OLED, and has a structure of ITO/PEDOT:PSS (50 nm)/PVK (35 nm)/CC6-DBP-PXZ (45 nm)/TmPyPB (40 nm)/LiF (1 nm)/Al (120 nm) (for details, refer to the reference document J. Mater. Chem. C, 2019, 7, 330-339).

A sixth light-emitting device is a polymer light-emitting diode (polymer light-emitting diode, PLED), and has a structure of ITO/PEDOT:PSS (50 nm)/CBP: 5% pTPE-TPA-FL (60 nm)/TmPyPB (40 nm)/LiF (1 nm)/Al (120 nm) (for details, refer to the reference document Mater. Chem. Front., 2020, 4, 1206-1211).

A seventh light-emitting device is a tandem OLED, and has a structure of ITO/HAT-CN (10 nm)/TAPC (50 nm)/TCTA (5 nm)/TCTA:Bepp2:Ir (ppy) 2 (acac) (1:1:8%, 20 nm)/Bepp2 (30 nm)/Liq (1.5 nm)/Al (0.5 nm)/HAT-CN (10 nm)/TAPC (75 nm)/TCTA (5 nm)/TCTA:Bepp2:Ir (ppy) 2 (acac) (1:1:8%, 20 nm)/Bepp2 (30 nm)/Liq (1.5 nm)/Al (0.5 nm)/HAT-CN (5 nm)/TAPC (10 nm)/Al (100 nm) (for details, refer to the reference document Org. Electron, 2020, 83, 105745).

It can be learned from FIG. 5A that, the natural logarithms *In*(Rₑ) of the internal resistances of the first light-emitting device to the seventh light-emitting device are in a linear relationship with the natural logarithms *In*(I) of the currents of the first light-emitting device to the seventh light-emitting device, and the natural logarithms *In*(Rₑ) of the internal resistances decrease linearly as the natural logarithms *In*(I) of the currents increase.

Specifically, corresponding to the natural logarithms *In*(Rₑ) of the internal resistances of the first light-emitting device to the seventh light-emitting device and the natural logarithms *In*(I) of the currents of the first light-emitting device to the seventh light-emitting device all satisfying the foregoing Formula (2), the curves of the natural logarithms *In*(Rₑ) of the internal resistances of the first light-emitting device to the seventh light-emitting device and the natural logarithms *In*(I) of the currents of the first light-emitting device to the seventh light-emitting device may be shown in Table 1 below.

**Table 1: Table of a relationship between a natural logarithm In(Rₑ) of an internal resistance of a light-emitting unit and a natural logarithm In(I) of a current of the light-emitting unit**

| Light-emitting device | Type of the light-emitting device | Light-emitting area/mm² | *In*(Rₑ)-*In*(I) curve | Goodness of fit R² |
|---|---|---|---|---|
| First light-emitting device | Single OLED | 16 | *In*(Rₑ)=-0.8941×*In*(I)+2.2577 | 0.9975 |
| Second light-emitting device | NIR OLED | 16 | *In*(Rₑ)=-0.8739×*In*(I)+2.4845 | 0.9987 |
| Third light-emitting device | PeLED | 16 | *In*(Rₑ)=-0.9027×*In*(I)+2.3626 | 0.9995 |
| Fourth light-emitting device | W-OLED | 16 | *In*(Rₑ)=-0.9032×*In*(I)+2.2413 | 0.9973 |
| Fifth light-emitting device | Solution-processed OLED | 16 | *In*(Rₑ)=-0.8727×*In*(I)+2.6416 | 0.9998 |
| Sixth light-emitting device | PLED | 16 | *In*(Rₑ)=-0.8857×*In*(I)+2.4765 | 0.9997 |
| Seventh light-emitting device | Tandem OLED | 16 | *In*(Rₑ)=-0.8808×*In*(I)+9.7313 | 0.9998 |

In Table 1, the goodness of fit R² represents a degree of similarity between the measured natural logarithm *In*(Rₑ) of the internal resistance of the light-emitting device and the natural logarithm *In*(I) of the current of the light-emitting device and the corresponding *In*(Rₑ)-*In*(I) curve, or a goodness of fit of fitting the natural logarithm *In*(Rₑ) of the internal resistance of the light-emitting device and the natural logarithm *In*(Iₑ) of the current of the light-emitting device to *In*(Rₑ)-*In*(I). If a value of the goodness of fit R² is closer to 1, it indicates that the measured natural logarithm *In*(Rₑ) of the internal resistance of the light-emitting unit and the natural logarithm In(I) of the current of the light-emitting unit better fit the *In*(Rₑ)-*In*(I) curve.

It can be learned from Table 1 and FIG. 5A that, both the natural logarithms *In*(Rₑ) of the internal resistances of the first light-emitting device and the seventh light-emitting device and the natural logarithms *In*(I) of the currents of the first light-emitting device and the seventh light-emitting device satisfy the curves defined in the foregoing Formula (1) and Formula (2). It can be learned from Formula (1) and Formula (2) that the resistance and the current of the light-emitting device do not comply with the Ohm's law. In some embodiments, a relationship between the internal resistance and the current of the light-emitting device defined in Formula (1) and Formula (2) may be referred to as the inverse Ohm's law.

In some embodiments, a light-emitting unit of the light-emitting device emits light when carriers (electronics, holes, and the like) are transported to the light-emitting layer, and there is a transition impedance in a process in which the carriers (electronics, holes, and the like) are transported in the light-emitting layer and emit light. Based on Formula (1) and Formula (2), when there is no defect in the light-emitting unit, α=1. In this case, the internal resistance of the light-emitting unit may be simplified to Rₑ=e^{δ}/I (equivalent to e^{δ}=RₑI), where Rₑ is equivalent to the transition impedance in the process in which the carriers (electronics, holes, and the like) are transported in the light-emitting layer and emit light, and e^{δ} is equivalent to a potential barrier between molecular orbits of the current transition of the carriers. Based on e^{δ}=RₑI, when I is a fixed value and Rₑ is a fixed value, e^{δ} is also a fixed value. However, for a same material, when an external condition (such as a temperature or a pressure) is unchanged, the potential barrier (equivalent to e^{δ}) between different molecular orbits is a fixed value (the law of constant energy gap). Therefore, the foregoing Formula (1) and Formula (2) also conform to the law of constant energy gap.

In some embodiments, refer to FIG. 5B. For a light-emitting unit of a subpixel, an HIL, an HTL, and an electron blocking layer (electron blocking layer, EBL) (used to block electron transport, for example, the foregoing auxiliary layer) are sequentially disposed from far to near on a side that is of the light-emitting unit and that is close to an anode. An HBL, an ETL, and an EIL are sequentially disposed from far to near on a side that is of the light-emitting unit and that is close to a cathode. A flow direction of the current is the HIL→the HTL→the ETL→the light-emitting unit→the HBL→the ETL→the EIL. Still refer to FIG. 5B. In the HIL, the HTL, the EBL, the HBL, the ETL and the EIT, the layers each have a thin film internal resistance (a sum of the thin film internal resistances of the layers is denoted as R_{CM} below), and there is an interface internal resistance between interfaces of two adjacent layers (a sum of the interface internal resistances of the interfaces is denoted as the sum of the thin film internal resistances R_{interface} below). Therefore, an equivalent resistor Rₜₒₜₐₗ corresponding to a light-emitting unit of a subpixel may be a sum of R_{CM}, R_{interface}, and Rₑ, that is, Rₜₒₜₐₗ=R_{CM}+R_{interface}+Rₑ.

In some embodiments, when a current density of a light-emitting unit of a subpixel is small, R_{CM} and R_{interface} are far less than Rₑ, and an equivalent resistance of the light-emitting unit is not affected. When the current density of the light-emitting unit of the subpixel is large, Rₑ decreases sharply, and R_{CM} and R_{interface} are close to Rₑ. Therefore, an internal resistance obtained through testing at both a cathode and an anode of the subpixel in which the light-emitting unit is located is greatly different from a transition impedance Rₑ. The current density of the light-emitting unit of the subpixel is usually small when the light-emitting unit is lit (when light-emitting luminance increases from 0 to a preset value, for example, 0.01 nit (nit) (or may be another value)), R_{CM} and R_{interface} may be ignored in the equivalent resistance of the light-emitting unit when the light-emitting unit is lit, so that Rₜₒₜₐₗ=Rₑ may be obtained through calculation based on Formula (1) or Formula (2).

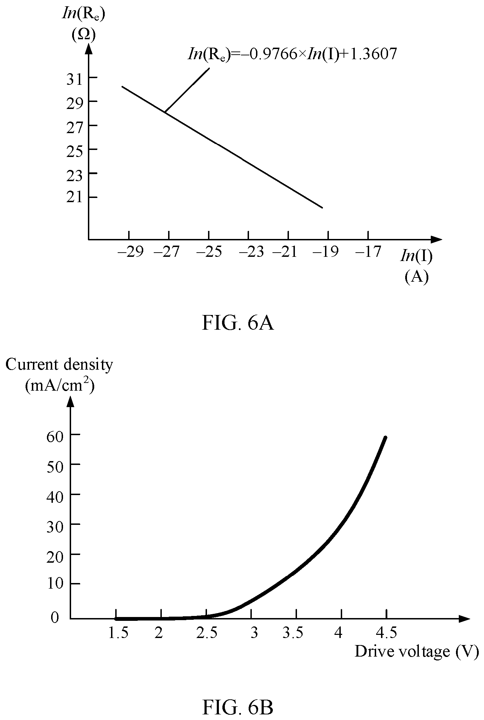

The following describes the technical solutions of this application by using an example in which an area of a light-emitting unit of a red subpixel is 20 µm×20 µm=400 µm², and a natural logarithm *In*(Rₑ) of an equivalent resistor of the light-emitting unit and a natural logarithm *In*(I) of a current satisfy a curve *In*(Rₑ)=-0.9766×*In*(I)+1.3607 shown in FIG. 6A.

With reference to FIG. 6A, it is assumed that a light-emitting current density of a light-emitting unit of a red subpixel is 0.0005 mA/cm² (that is, when the current density of the light-emitting unit is lower than the light-emitting current density of 0.0005 mA/cm², it may be considered that the light-emitting unit does not emit light or emits weak light), and a corresponding current is 0.0005 mA/cm²×400 µm²=2×10⁻¹² A. In this case, a corresponding equivalent resistance of 1038 GΩ (equivalent to that the resistance of the red light-emitting unit R1-2 in FIG. 2B is 1038 GΩ) of the light-emitting unit may be obtained by substituting the current into the foregoing formula "*In*(Rₑ)=-0.9766×*In*(2×10⁻¹²)+1.3607". This is equivalent to that a voltage value at two ends of the light-emitting unit is 1038 GΩ×0.0005 mA/cm²×400 µm²=2.08 V (equivalent to that the voltage at two ends of the red light-emitting unit R1-2 in FIG. 2B is 2.08 V).

It is assumed that a light-emitting voltage of a blue light-emitting unit of a blue subpixel is 2.4 V (equivalent to that the voltage at two ends of the blue light-emitting unit B1-1/B1-2 in FIG. 2B is 2.4 V, that is, V_{CGL}-ELVSS=2.4 V), and a voltage division of the red light-emitting unit R1-2 to V_{CGL} is R_{R1-2}/(R_{R1-2}+R_{CGL})×(V_{CGL}-ELVSS)=2.08 V, that is, 1038 GΩ/(1038 GΩ+R_{CGL})×2.4 V=2.08 V. When 1038 GΩ/(1038 GΩ+R_{CGL})×2.4 V=2.08 V, and the current density of the red light-emitting unit R1-2 reaches the light-emitting current density, R_{CGL}=1038 GΩ×2.4 V/2.08 V-1038 GΩ/=159.7 GΩ. Refer to FIG. 6B. The current density of the light-emitting unit of the red subpixel increases as the drive voltage increases. If the equivalent resistance of the CGL is greater than 159.7 GΩ, the voltage at two ends of the red light-emitting unit R1-2 is less than 2.08 V, the current density of the red light-emitting unit R1-2 is less than 0.0005 mA/cm², and the red light-emitting unit R1-2 does not emit light. In other words, when a PDL gap is 20 µm, if the equivalent resistance of the CGL is greater than 159.7 GΩ/□, the current density of the red light-emitting unit R1-2 is less than 0.0005 mA/cm² (not reaching the light-emitting current density of the red light-emitting unit R1-2). In this way, pixel crosstalk between the blue subpixel and the red subpixel does not occur.

In some embodiments, a drive voltage of the blue subpixel is greater than a drive voltage of the green subpixel, and the drive voltage of the green subpixel is greater than a drive voltage of the red subpixel. Therefore, a voltage obtained by each subpixel by dividing a drive voltage of a subpixel of another color except the blue subpixel is less than a voltage obtained by dividing the drive voltage of the blue subpixel. In other words, when pixel crosstalk does not occur between the blue subpixel and the red subpixel, pixel crosstalk does not occur between the green subpixel and the red subpixel, or between the blue subpixel and the red subpixel.

In some embodiments, when another condition is fixed, a sheet resistance of the thin film increases as a thickness decreases. Therefore, the thickness of the i-CGL is reduced, so that the overall sheet resistance of the CGL can be increased. As a result, the voltage value obtained by the light-emitting unit of the subpixel by dividing the drive voltage of the another subpixel is less than the light-emitting voltage of the light-emitting unit, and crosstalk between subpixels is avoided. For example, in the cases shown in FIG. 6A and FIG. 6B, the thickness of the i-CGL may be reduced, so that the sheet resistance of the CGL is greater than 159.7 GΩ/□. In this way, the red light-emitting unit R1-2 does not emit light incorrectly due to the blue light-emitting unit B1-1/B1-2.

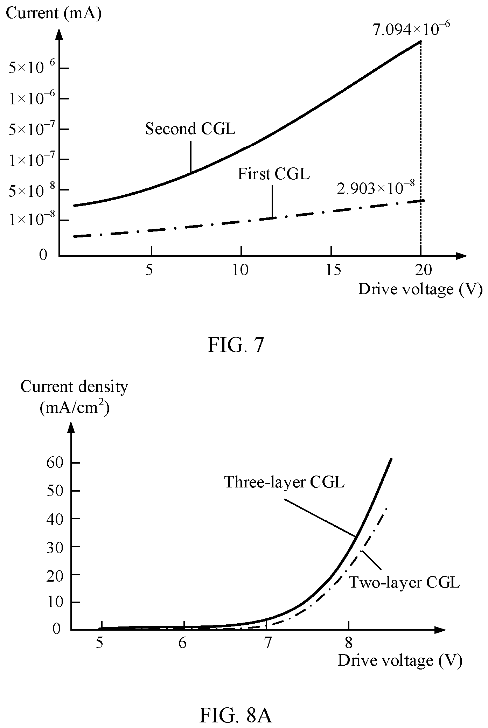

For example, FIG. 7 is a diagram of curves of currents and drive voltages of CGLs when thicknesses of i-CGLs are different according to some embodiments of this application.

In the case shown in FIG. 7, a horizontal axis represents the drive voltage, a vertical axis represents the current.

The first CGL is: ITO/ET: 1.5% Yb (10 nm)/HATCN (2.5 nm)/HT: 3% NDP-9 (10 nm)/ITO, that is, a structure in which an indium tin oxide electrode, an N-CGL (with a thickness of 10 nm, prepared by doping 1.5% Yb in an electron transport material), an i-CGL (with a thickness of 2.5 nm, prepared by using HATCN), a P-CGL (with a thickness of 10 nm, prepared by doping 3% NDP-9 in a hole transport material), and an indium tin oxide electrode that are stacked. For details, refer to the reference document (SID 2022 DIGEST, 877-880).

The second CGL is: ITO/ET: 1.5% Yb (10 nm)/HATCN (5 nm)/HT: 3% NDP-9 (10 nm)/ITO, that is, a structure in which an indium tin oxide electrode, an N-CGL (with a thickness of 10 nm, prepared by doping 1.5% Yb in an electron transport material), an i-CGL (with a thickness of 2.5 nm, prepared by using HATCN), a P-CGL (with a thickness of 10 nm, prepared by doping 3% NDP-9 in a hole transport material), and an indium tin oxide electrode that are stacked. For details, refer to the reference document (SID 2022 DIGEST, 877-880).

In other words, a difference between the first CGL and the second CGL lies in that the i-CGL is different in thickness.

As shown in FIG. 7, the current of the first CGL remains at an order of magnitude of 10⁻⁸ mA as the drive voltage increases, and the current of the first CGL increases from an order of magnitude of 10⁻⁸ mA to an order of magnitude of 10⁻⁶ mA as the drive voltage increases. For example, when the drive voltage is 20 V, the current of the first CGL is 2.903×10⁻⁸ mA, and the sheet resistance of the CGL is 20 V/2.903×10⁻⁸ mA=688.9 GΩ/□. When the drive voltage is 20 V, the current of the second CGL is 7.094×10⁻⁶ mA, and the sheet resistance is 20 V/7.094×10⁻⁶ mA=2.8 GΩ/□. The sheet resistance of the first CGL is 244 times the sheet resistance of the second CGL.

In some embodiments, the i-CGL has a charge generation capability. Therefore, when a same charge generation capability is provided, a doping concentration of the P-CGL in the three-layer CGL is lower than a doping concentration of the two-layer P-CGL, and a doping concentration of the N-CGL in the three-layer CGL is lower than a doping concentration of the two-layer N-CGL. Correspondingly, the sheet resistance of the three-layer CGL is greater than the sheet resistance of the two-layer CGL. Therefore, using the three-layer CGL including the N-CGL, the i-CGL, and the P-CGL provided in this embodiment of this application helps increase the sheet resistance of the CGL.

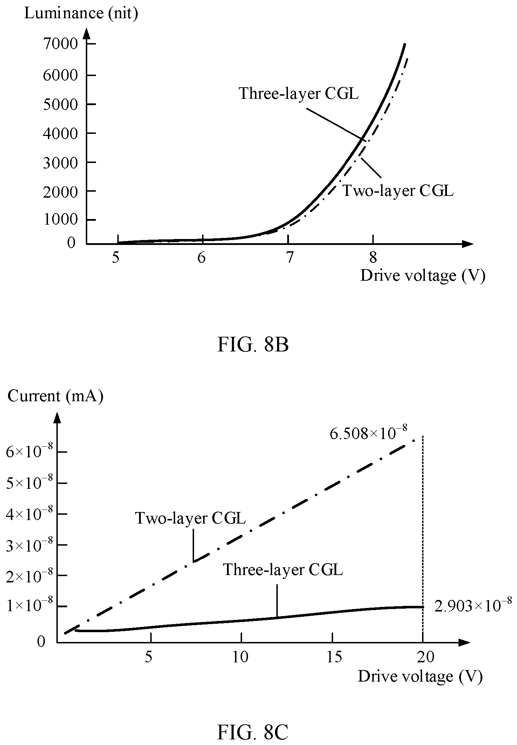

For example, FIG. 8A is a diagram of curves in which a current density of a light-emitting layer varies with a drive voltage in a display panel using a two-layer CGL and a three-layer CGL according to some embodiments of this application. FIG. 8B is a diagram of curves in which light-emitting luminance of a light-emitting unit varies with a drive voltage in a display panel using a two-layer CGL and a three-layer CGL according to some embodiments of this application. FIG. 8C is a diagram of comparison between a current in a two-layer CGL and a current in a three-layer CGL according to some embodiments of this application.

In the cases shown in FIG. 8A to FIG. 8C:
A structure of the two-layer CGL is ET. 1.5% Yb (10 nm)/HT: 10% NDP-9 (10 nm). To be specific, the N-CGL is 10 nm in thickness and is prepared by doping 1.5% Yb in an electronic transport material, and the P-CGL is 10 nm in thickness and is prepared by doping 10% NDP-9 in a hole transport material. For details, refer to the reference document (SID 2022 DIGEST, 877-880).

A structure of the three-layer CGL is ET. 1.5% Yb (10 nm)/HATCN (2.5 nm)/HT: 3% NDP-9 (10 nm). To be specific, the N-CGL is 10 nm in thickness and is prepared by doping 1.5% Yb in an electronic transport material, the i-CGL is 2.5 nm in thickness and is prepared by using HATCN, and the P-CGL is 10 nm in thickness and is prepared by doping 3% NDP-9 in a hole transport material. Compared with the two-layer CGL, in the three-layer CGL, the doping concentration of the P-CGL was reduced from 10% to 3%. For details, refer to the reference document (SID 2022 DIGEST, 877-880).

Refer to 8A. Both the current density of the light-emitting layer in the display panel using the two-layer CGL and the current density of the light-emitting layer in the display panel using the three-layer CGL increase as the drive voltage increases. However, under a same drive voltage, the current density of the light-emitting layer in the display panel using the three-layer CGL is higher than the current density of the CGL in the display panel using the two-layer CGL. Under a same voltage, a higher current density provided by the CGL to the light-emitting layer indicates a stronger charge generation capability of the CGL. Therefore, it can be learned that the charge generation capability of the three-layer CGL is higher than the charge generation capability of the two-layer CGL.

Refer to FIG. 8B. Both the light-emitting luminance of the light-emitting unit in the display panel using the two-layer CGL and the light-emitting luminance of the light-emitting unit in the display panel the three-layer CGL increase as the drive voltage increases. Under a same drive voltage, the light-emitting luminance of the CGL in the display panel using the three-layer CGL is higher than the light-emitting luminance of the CGL in the display panel using the two-layer CGL. When the light-emitting units reach same luminance, the drive voltage required by the display panel using the three-layer CGL is lower than the drive voltage required by the display panel using the two-layer CGL. In this way, the display panel provided in this embodiment of this application can reduce power consumption.

Refer to FIG. 8C. Both the current of the two-layer CGL and the current of the three-layer CGL increase as the drive voltage increases. However, a rate at which the current of the three-layer CGL increases (a larger slope of the curve indicates a larger increase rate) with the drive voltage is far lower than a rate at which the current of the two-layer CGL increase with the drive voltage. In addition, under a same drive voltage, the current in the three-layer CGL is far lower than the current in the two-layer CGL. When the voltage is fixed, the sheet resistance is inversely proportional to the current. Therefore, the sheet resistance of the three-layer CGL is greater than the sheet resistance of the two-layer CGL. For example, when the drive voltage is 20 V, the current in the three-layer CGL is 7.21×10⁻⁹ mA, and the sheet resistance of the CGL is 20 V/7.21×10⁻⁹ mA=2774 GΩ/□; and the current in the two-layer CGL is 6.508×10⁻⁸ mA, and the sheet resistance of the CGL is 20 V/6.508×10⁻⁸ mA=305 GΩ/□. In other words, the three-layer CGL is used. When the drive voltage is 20 V, the sheet resistance of the three-layer CGL is about (2774-305)/305=8.1 times greater than the sheet resistance of the two-layer CGL.

In some embodiments, a Fermi level of the i-CGL is lower than a Fermi level of a host material in the P-CGL. An accumulation junction is formed between the i-CGL and the P-CGL. Electrons tunnel from the P-CGL to the i-CGL, thereby reducing an energy level transition barrier. In this way, the drive voltage of the display panel may be reduced, thereby reducing power consumption of the display panel. The following describes a specific principle of reducing the drive voltage of the display panel when the Fermi level of the i-CGL is lower than that of the P-CGL.

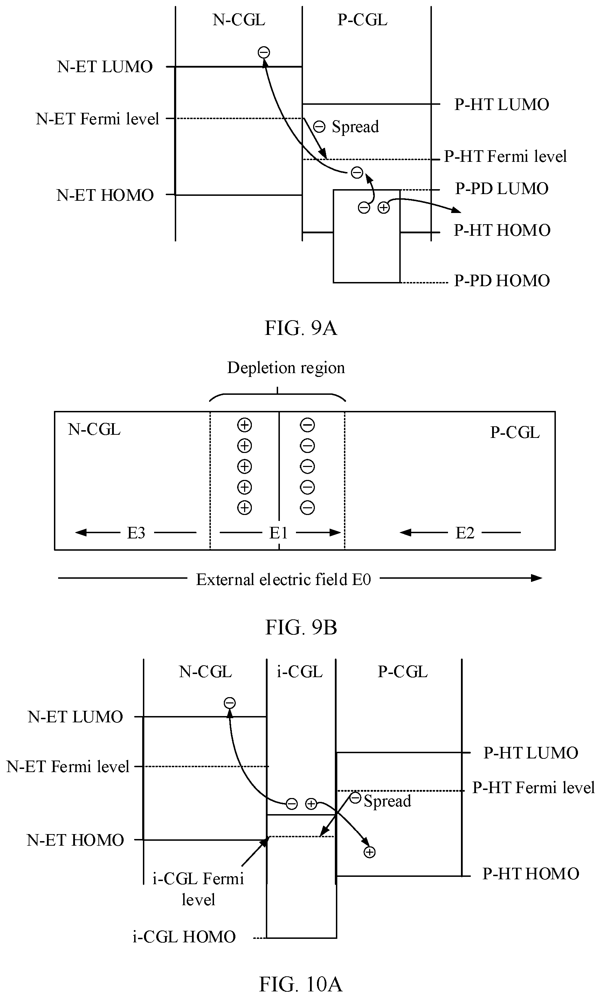

For example, FIG. 9A is a diagram of an energy level of a two-layer CGL. FIG. 9B is a diagram of an electric field of a two-layer CGL.

As shown in FIG. 9A, in the two-layer CGL, a Fermi level of a material (N-ET) used for transporting electrons in the N-CGL is close to that of a material (P-HT) used for transporting holes in the P-CGL, and the Fermi level of the N-ET is higher than the Fermi level of the P-HT. Electrons are diffused from the N-CGL to the P-CGL. As a result, electrons on a side that is of the N-CGL and that is close to the P-CGL decrease and a proportion of holes increases, and electrons on a side that is of the P-CGL and that is close to the N-CGL increase and a proportion of holes decreases. Refer to FIG. 9B. In this way, a depletion region is formed in a region close to the N-CGL and the P-CGL. A built-in electric field E1 pointing from the N-CGL to the P-CGL exists in the depletion region. A built-in electric field E2 exists in a region other than the depletion region in the P-CGL and a built-in electric field E3 exists in a region other than the depletion region in the N-CGL respectively, and the built-in electric field E2 and the built-in electric field E3 are in an opposite direction to the built-in electric field E1.

After a drive voltage is applied to the two-layer CGL, an external electric field E0 pointing from the N-CGL to the P-CGL exists, to drive holes generated at an interface between the N-CGL and the P-CGL to move in a direction of the external electric field E0, and drive electrons generated at the interface between the N-CGL and the P-CGL to move in a direction opposite to that of the external electric field E0. The direction of the external electric field E0 is opposite to the direction of the built-in electric field E2 and the built-in electric field E3. As a result, the built-in electric field E2 and the built-in electric field E3 prevent the holes and the electrons from moving in the corresponding directions. In other words, in addition to providing a voltage for migration of the holes and the electrons, the external electric field E0 needs to provide a voltage for overcoming the built-in electric field E2 and the built-in electric field E3. Therefore, as operating time of the display panel increases, intensity of the built-in electric field E1 become greater. Correspondingly, the built-in electric field E2 and the built-in electric field E3 increase. In addition, in the drive voltage, the voltage for overcoming the built-in electric field E2 and the built-in electric field E3 increases, and the drive voltage required for driving the display panel to emit light of the same luminance increases.

In the three-layer CGL, a Fermi level of the i-CGL is lower than that of the P-CGL. An accumulation junction is formed between the i-CGL and the P-CGL. Compared with the two-layer CGL, this may reduce the drive voltage.

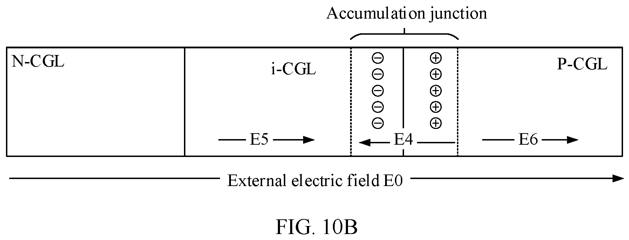

Specifically, FIG. 10A is a diagram of an energy level of a three-layer CGL. FIG. 10B is a diagram of a direction of a built-in electric field of a three-layer CGL.

As shown in FIG. 10A, in the three-layer CGL, a Fermi level of the i-CGL is lower than a Fermi level of the P-HT and a Fermi level of the N-ET. Therefore, when there is no external electric field, electrons in the P-CGL migrate to the i-CGL. As a result, electrons on a side that is of the i-CGL and that is close to the P-CGL increase and a proportion of holes decreases, and electrons on a side that is of the P-CGL and that is close to the i-CGL decrease and a proportion of holes increases. Refer to FIG. 10B. In this way, an accumulation junction region is formed in a region near the interface between the i-CGL and the P-CGL, and a built-in electric field E4 pointing from the P-CGL to the i-CGL exists in the accumulation junction region. Correspondingly, a built-in electric field E5 exists in a region other than the accumulation junction region in the i-CGL and a built-in electric field E6 exists in a region other than the depletion region in the P-CGL respectively, and the built-in electric field E5 and the built-in electric field E6 are in a same direction as the built-in electric field E4.

After a drive voltage is applied to the three-layer CGL, an external electric field E0 pointing from the N-CGL to the P-CGL exists, to drive holes generated at the i-CGL (which may alternatively be the N-CGL or the P-CGL) to move in a direction of the external electric field E0, and drive electrons generated at the interface between the N-CGL and the P-CGL to move in a direction opposite to that of the external electric field E0. The direction of the external electric field E0 is the same as the direction of the built-in electric field E5 and the built-in electric field E6. As a result, the built-in electric field E5 and the built-in electric field E6 do not prevent the holes and the electrons from moving in the corresponding directions. In other words, the external electric field E0 does not need to provide a voltage for overcoming the built-in electric field E5 and the built-in electric field E6. Compared with the two-layer CGL, this does not increase the drive voltage required for driving the display panel to emit light of the same luminance.

The following describes a structure of the display panel that includes the foregoing three-layer CGL provided in this embodiment of this application with reference to a specific pixel composition manner.

In some embodiments, one pixel may include subpixels of a plurality of colors, for example, subpixels of three colors such as a red subpixel, a green subpixel, and a blue subpixel; or subpixels of four colors such as a red subpixel, a green subpixel, a blue subpixel, and a cyan subpixel; or subpixels of four colors such as a red subpixel, a green subpixel, a blue subpixel, and a cerulean subpixel; or subpixels of four colors such as a red subpixel, a green subpixel, a blue subpixel, and a white subpixel. A subpixel of one color may be referred to as a primary color. The display panel may change light-emitting luminance of different primary colors in a same pixel, so that a plurality of primary colors are mixed into different colors.

In some embodiments, there may be one or more subpixels of one color in one pixel. For example, when one pixel includes subpixels of three colors, the pixel may include three subpixels of different colors. When one pixel includes subpixels of four colors, the pixel may include four subpixels of different colors. For another example, when one pixel includes subpixels of three colors, the pixel may include four subpixels, and there are two subpixels of a same color in the four subpixels.

In some embodiments, a shape of a light-emitting unit of a subpixel may be a circle, an ellipse, a rectangle, a rhombus, or another polygon or irregular shape.

In some embodiments, colors of a plurality of light-emitting units of a subpixel of one color may be the same or different. For example, the subpixel of one color may include a plurality of light-emitting units that are respectively disposed at different light-emitting layers and whose light-emitting colors are the same as the color. For another example, light-emitting units of the subpixel of one color may include a plurality of light-emitting units of different light-emitting colors that are respectively disposed at different light-emitting layers.

In some embodiments, sizes of subpixels of different colors may be the same or different.

The following describes, by using an example in which the display panel includes two light-emitting layers, the technical solutions of the display panel that includes the foregoing three-layer CGL provided in this application with reference to a quantity, colors, shapes, arrangement rules, and the like of subpixels in one pixel.

Implementation 1: One pixel on the display panel includes a red subpixel, a green subpixel, and a blue subpixel, and a subpixel of each color includes a plurality of light-emitting units whose light-emitting colors are the same as the color of the subpixel.

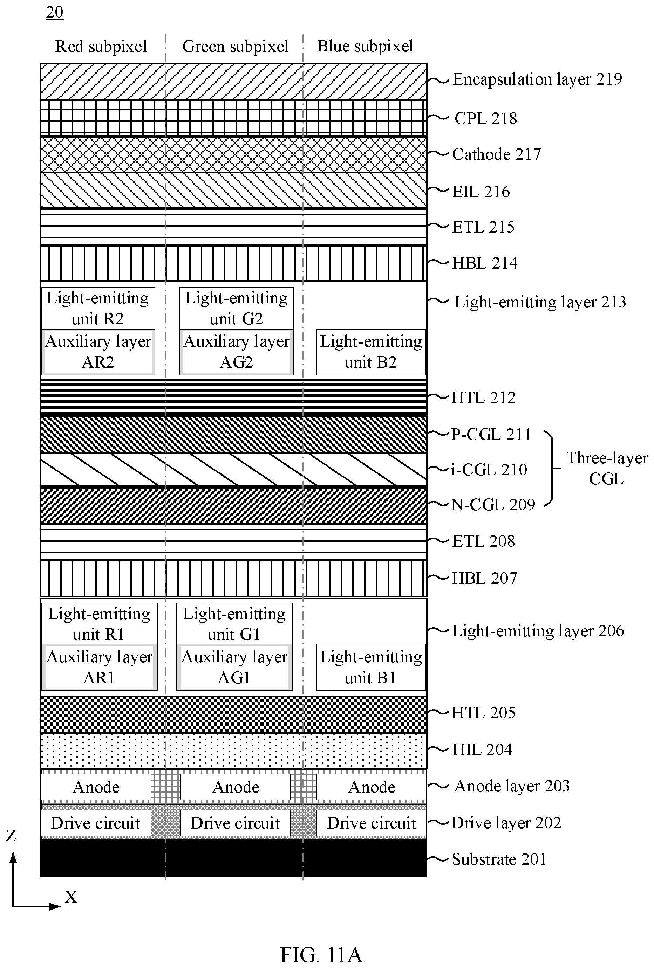

For example, FIG. 11A is a diagram of a structure of subpixels of different colors on a display panel 20 according to some embodiments of this application.

As shown in FIG. 11A, a CGL in the display panel 20 is the foregoing three-layer CGL. Specifically, the display panel 20 includes a substrate 201, a drive layer 202, an anode layer 203, an HIL 204, an HTL 205, a light-emitting layer 206, an HBL 207, an ETL 208, an N-CGL 209, an i-CGL 210, a P-CGL 211, an HTL 212, a light-emitting layer 213, an HBL 214, an ETL 215, an EIL 216, a cathode 217, a CPL 218, and an encapsulation layer 219 that are sequentially stacked in a Z direction. The HBL 207 and the HBL 214 are optional. For functions and materials of the layers, refer to related content in the display panel 10. This is not limited herein.

For the red subpixel, the light-emitting layer 206 may include an auxiliary layer AR1 and a red light-emitting unit R1 that are sequentially stacked. The auxiliary layer AR1 is disposed on a side that is of the light-emitting layer 1 and that is close to the HTL 205. The light-emitting layer 213 may include an auxiliary layer AR2 and a red light-emitting unit R2 that are sequentially stacked. The auxiliary layer AR2 is disposed on a side that is of the light-emitting layer 213 and that is close to the HTL 212.

For the green subpixel, the light-emitting layer 206 may include an auxiliary layer AG1 and a green light-emitting unit G1 that are sequentially stacked. The auxiliary layer AG1 is disposed on the side that is of the light-emitting layer 206 and that is close to the HTL 205. The light-emitting layer 213 may include an auxiliary layer AG2 and a green light-emitting unit G2 that are sequentially stacked. The auxiliary layer AG2 is disposed on the side that is of the light-emitting layer 213 and that is close to the HTL 212.

For the blue subpixel, the light-emitting layer 206 may include a blue light-emitting unit B1, and the light-emitting layer 213 may include a blue light-emitting unit B2.

In some embodiments, light-emitting units of a same color in a light-emitting layer may be prepared by using a fine metal mask (fine metal mask, FMM). The FMM may include a plurality of openings, and sizes and positions of the openings are corresponding to sizes and positions of the light-emitting units. In some embodiments, auxiliary layers of a same color in a light-emitting layer may be prepared by using one FMM. The FMM may include a plurality of openings, and positions of the openings correspond to sizes and positions of the light-emitting units. Based on this, for the display panel 20 shown in FIG. 11A, the light-emitting layers may be prepared by using 10 FMMs. The 10 FMMs are respectively: three FMMs corresponding to light-emitting units of three colors in the light-emitting layer 206, two FMMs corresponding to the auxiliary layer AR1 and the auxiliary layer AG1 in the light-emitting layer 206, three FMMs corresponding to light-emitting units of three colors in the light-emitting layer 213, and two FMMs corresponding to the auxiliary layer AR2 and the auxiliary layer AG2 in the light-emitting layer 213.

In other words, in the display panel 20 shown in FIG. 11A, an auxiliary layer is disposed between a light-emitting unit of the red subpixel and a light-emitting unit of the green subpixel at each light-emitting layer and a hole transport layer adjacent to the light-emitting layer. However, no auxiliary layer is disposed between a light-emitting unit of the blue subpixel at each light-emitting layer and a hole transport layer adjacent to the light-emitting layer.

It should be noted that, in some other embodiments, according to different manufacturing processes and different light-emitting requirements (for example, light-emitting luminance, color gamut, and light-emitting efficiency) on the display panel, a corresponding auxiliary layer may be added or reduced. Correspondingly, a quantity of FMMs required for preparing a light-emitting layer may be increased or reduced.

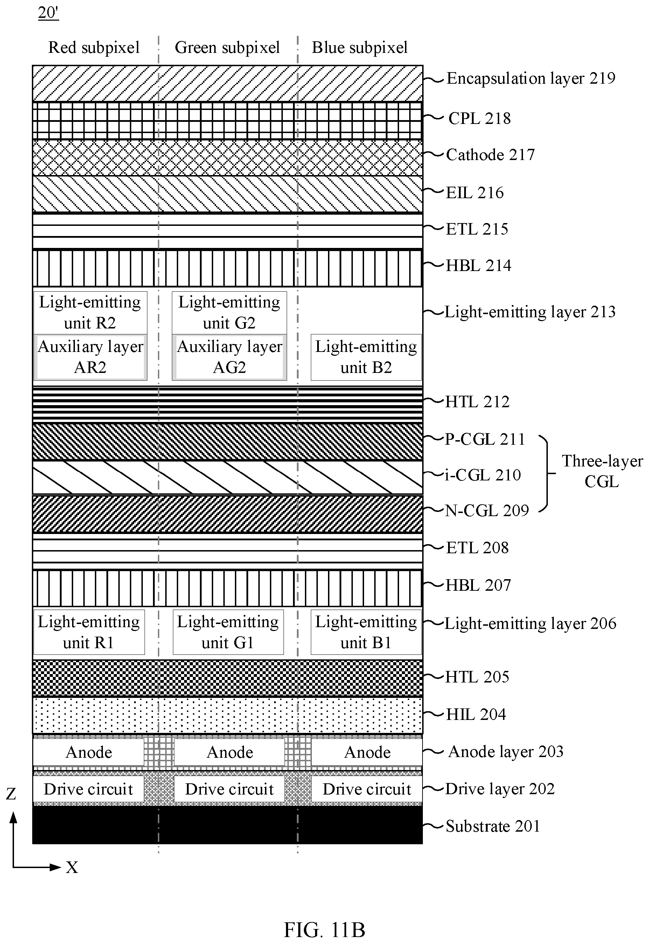

For example, refer to FIG. 11B. Compared to the display panel 20, in the display panel 20', no auxiliary layer is disposed between the HTL 205 and the light-emitting unit R1 of the red subpixel and the light-emitting unit G1 of the green subpixel at the light-emitting layer 206. Therefore, only eight FMMs may be used for preparing the light-emitting units in the display panel 20'.

It should be noted that, in FIG. 11A and FIG. 11B, that no auxiliary layer is disposed between the light-emitting unit of the blue subpixel and the adjacent HTL is merely an example. In some other embodiments, no auxiliary layer may be disposed between light-emitting units of subpixels of one or more other colors and an adjacent HTL, or an auxiliary layer may be disposed between light-emitting units of subpixels of all colors and an adjacent HTL. This is not limited herein.

For example, in some embodiments, an auxiliary layer may be disposed between the HTL 205 and the light-emitting unit of the red subpixel and the light-emitting unit of the blue subpixel at the light-emitting layer 206. An auxiliary layer may be disposed between the HTL 212 and the light-emitting unit of the red subpixel and the light-emitting unit of the blue subpixel at the light-emitting layer 213. However, no auxiliary layer is disposed between the light-emitting unit of the green subpixel and the adjacent HTL.

For another example, in some embodiments, an auxiliary layer may be disposed between the HTL 205 and the light-emitting unit of the green subpixel and the light-emitting unit of the blue subpixel at the light-emitting layer 206. An auxiliary layer may be disposed between the HTL 212 and the light-emitting unit of the green subpixel and the light-emitting unit of the blue subpixel at the light-emitting layer 213. However, no auxiliary layer is disposed between the light-emitting unit of the red subpixel and the adjacent HTL.

Corresponding to the cases shown in FIG. 11A and FIG. 11B, shapes, arrangement orders, and quantities of subpixels may be arranged in a plurality of different manners.

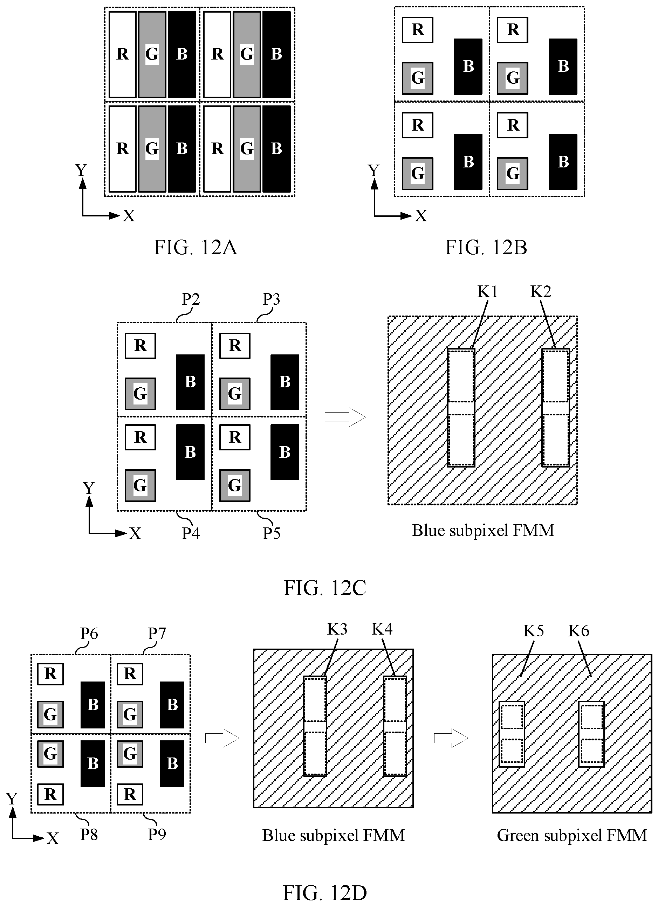

For example, FIG. 12A to FIG. 12F are diagrams of a plurality of subpixel arrangement manners.

For example, refer to FIG. 12A. One pixel may include three rectangular subpixels, namely, a red subpixel, a green subpixel, and a blue subpixel. In each pixel, a distribution manner of the red subpixel, the green subpixel, and the blue subpixel is the same. In addition, the red subpixel, the green subpixel, and the blue subpixel may be sequentially arranged in an X direction in an order of the red subpixel, the green subpixel, and the blue subpixel. In other words, one pixel may include three columns of subpixels, and subpixels of each color occupy one column.

Optionally, in some embodiments, in each pixel, the red subpixel, the green subpixel, and the blue subpixel may alternatively be sequentially arranged in a Y direction. In other words, one pixel may include three rows of subpixels, and subpixels of each color occupy one row.

Optionally, in some embodiments, in each pixel, the red subpixel, the green subpixel, and the blue subpixel may alternatively be sequentially arranged in the X direction or the Y direction in an order of the green subpixel, the blue subpixel, and the red subpixel, or in an order of the green subpixel, the red subpixel, and the blue subpixel, or in an order of the red subpixel, the blue subpixel, and the green subpixel, or in an order of the blue subpixel, the red subpixel, and the green subpixel, or in an order of the blue subpixel, the green subpixel, and the red subpixel.

Optionally, sizes of the three rectangular subpixels in one pixel may be the same or different.

For example, refer to FIG. 12B. One subpixel may include three rectangular subpixels, namely, a red subpixel, a green subpixel, and a blue subpixel. In each pixel, a distribution manner of the red subpixel, the green subpixel, and the blue subpixel is the same. In addition, the green subpixel and the red subpixel are sequentially arranged in the Y direction (equivalent to that the green subpixel and the red subpixel are arranged in a column), and the blue subpixel and the red subpixel are sequentially arranged in the X direction (equivalent to that the blue subpixel and the red subpixel (green subpixel) are arranged in different columns). In other words, one pixel includes two columns of pixels. The red subpixel and the green subpixel are arranged in one column, and the blue subpixel is arranged in the other column.

Optionally, in some embodiments, in each pixel, positions of the red subpixel and the green subpixel may be exchanged.

Optionally, in some embodiments, subpixels of any two colors of subpixels of three colors may be located in a same column, and subpixels of another color are arranged in another column.

For example, refer to FIG. 12C. One pixel may include three rectangular subpixels, namely, a red subpixel, a green subpixel, and a blue subpixel. In each pixel, a distribution manner of the red subpixel and the green subpixel is the same. In addition, the green subpixel and the red subpixel are sequentially arranged in the Y direction (equivalent to that the green subpixel and the red subpixel are arranged in a column), and the blue subpixel and the red subpixel are sequentially arranged in the X direction (equivalent to that the blue subpixel and the red subpixel (green subpixel) are arranged in different columns). In addition, blue subpixels in two adjacent pixels in the Y direction (namely, two adjacent pixels in a same column) are respectively close to different sides of pixels in which the blue subpixels are located in the Y direction. In pixels in a same row, locations of the blue subpixels relative to the pixels in which the blue subpixels are located are the same. For example, a pixel P2 and a pixel P4 are adjacent in the Y direction. A blue subpixel in the pixel P2 is close to a lower edge of the pixel P2, and a blue subpixel in the pixel P4 is close to an upper edge of the pixel P4. For another example, the pixel P2 and a pixel P3 are in a same row. The blue subpixel in the pixel P2 is close to the lower edge of the pixel P2, and a blue subpixel in the pixel P3 is close to a lower edge of the pixel P3. The pixel P4 and a pixel P5 are in a same row. The blue subpixel in the pixel P4 is close to the upper edge of the pixel P4, and a blue subpixel in the pixel P5 is close to an upper edge of the pixel P5.

A light-emitting unit is prepared by using an FMM. Therefore, a size of an opening in the FMM corresponds to a size of the light-emitting unit. In the subpixel arrangement manner shown in FIG. 12C, when a light-emitting unit of the blue subpixel is prepared, the blue subpixels in two pixels that are adjacent in the Y direction and in which the blue subpixels are close to a boundary between the two pixels may be prepared by using one opening. In other words, in the FMM corresponding to the blue subpixel, a size of the opening is greater than or equal to a sum of sizes of two blue subpixels. In this way, manufacturing of an opening with a small size in the FMM can be avoided, and manufacturing costs are reduced. For example, for the pixels P2 to P5 in FIG. 12C, the blue subpixel in the pixel P2 and the blue subpixel in the pixel P3 are close to a boundary between the pixel P2 and the pixel P4, and the blue subpixel in the pixel P2 and the blue subpixel in the pixel P4 may be prepared by using an opening K1 in the FMM. The blue subpixel in the pixel P3 and the blue subpixel in the pixel P5 are close to a boundary between the pixel P3 and the pixel P5, and the blue subpixel in the pixel P3 and the blue subpixel in the pixel P5 may be prepared by using an opening K2 in the FMM.

In some embodiments, for the subpixel arrangement manner shown in FIG. 12C, locations of subpixels of different colors on the display panel may alternatively be exchanged. For example, a location of a red subpixel on the display panel is exchanged with a location of a blue subpixel on the display panel, and/or a location of a red subpixel on the display panel is exchanged with a location of a green subpixel on the display panel, and/or a location of a blue subpixel on the display panel is exchanged with a location of a green subpixel on the display panel. This is not limited herein.

Refer to FIG. 12D. In some embodiments, one subpixel may include three rectangular subpixels, namely, a red subpixel, a green subpixel, and a blue subpixel. In each pixel, the green subpixel and the red subpixel are arranged in the Y direction (equivalent to that the green subpixel and the red subpixel are arranged in a column), and the blue subpixel and the red subpixel are arranged in the X direction (equivalent to that the blue subpixel and the red subpixel (green subpixel) are arranged in different columns). Arrangement manners of subpixels in two adjacent pixels in a same column are mirrored around the X direction, and arrangement manners of subpixels in pixels in a same row are the same. In other words, in the two adjacent pixels in the same column, red subpixels and green subpixels are arranged in a reverse order in the Y direction, and blue subpixels are respectively close to different sides of the pixels in which the blue subpixels are located in the Y direction.

For example, a pixel P6 and a pixel P8 are adjacent pixels in a same column. In the pixel P6, a red subpixel is above the red subpixel, and a blue subpixel is close to a lower edge of the pixel P6. In the pixel P8, a green subpixel is above the red subpixel, and a blue subpixel is close to an upper edge of the pixel P8. For another example, the pixel P6 and a pixel P7 are pixels in a same row, for which subpixel arrangement manners are the same.

Based on the subpixel arrangement manner shown in FIG. 12D, each subpixel except a subpixel in an edge region of the display panel is close to another subpixel of a same color in the Y direction. Therefore, the openings of the FMMs for manufacturing the red subpixel, the green subpixel, and the blue subpixel may be greater than twice the size of the red subpixel, twice the size of the green subpixel, and twice the size of the blue subpixel respectively. In this way, manufacturing of an opening with a small size in the FMM can be avoided, and manufacturing costs are reduced.

For example, for the pixels P6 to P9 in FIG. 12D, the blue subpixel in the pixel P6 and the blue subpixel in the pixel P8 are close to a boundary between the pixel P6 and the pixel P8, and the blue subpixel in the pixel P6 and the blue subpixel in the pixel P8 may be prepared by using an opening K3 in the FMM. The blue subpixel in the pixel P7 and the blue subpixel in the pixel P9 are close to a boundary between the pixel P7 and the pixel P9, and the blue subpixel in the pixel P7 and the blue subpixel in the pixel P9 may be prepared by using an opening K4 in the FMM. Similarly, the green subpixel in the pixel P6 and the green subpixel in the pixel P8 may be prepared by using an opening K5 in the FMM, and the green subpixel in the pixel P7 and the green subpixel in the pixel P9 may be prepared by using an opening K6 in the FMM.

In some embodiments, for the subpixel arrangement manner shown in FIG. 12D, locations of subpixels of different colors on the display panel may alternatively be exchanged. For example, a location of a red subpixel on the display panel is exchanged with a location of a blue subpixel on the display panel, and/or a location of a red subpixel on the display panel is exchanged with a location of a green subpixel on the display panel, and/or a location of a blue subpixel on the display panel is exchanged with a location of a green subpixel on the display panel. This is not limited herein.

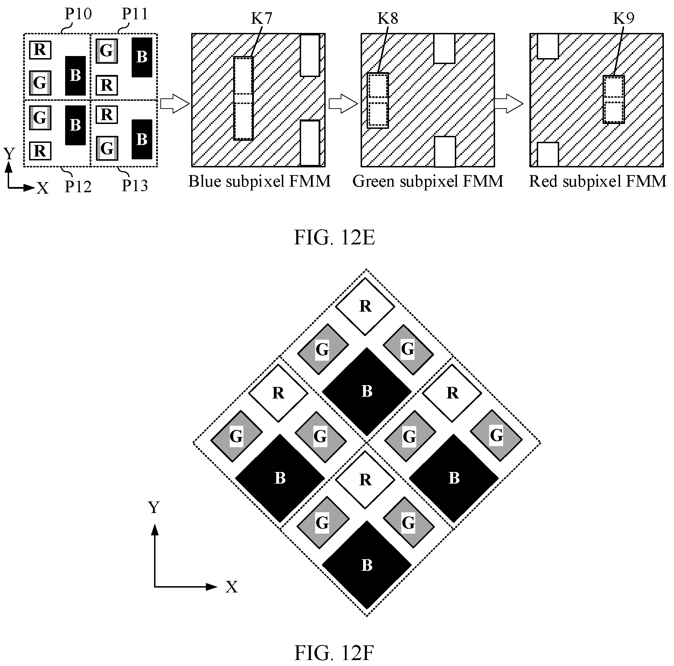

Refer to FIG. 12E. In some embodiments, one subpixel may include three rectangular subpixels, namely, a red subpixel, a green subpixel, and a blue subpixel. In each pixel, the green subpixel and the red subpixel are arranged in the Y direction (equivalent to that the green subpixel and the red subpixel are arranged in a column), and the blue subpixel and the red subpixel are arranged in the X direction (equivalent to that the blue subpixel and the red subpixel (green subpixel) are arranged in different columns). Arrangement manners of subpixels in two adjacent pixels are mirrored around the X direction. In other words, in the two adjacent pixels, red subpixels and green subpixels are arranged in a reverse order in the Y direction, and blue subpixels are respectively close to different sides of the pixels in which the blue subpixels are located in the Y direction.

For example, in a pixel P10, a red subpixel is above a green subpixel, and a blue subpixel is close to a lower edge of the pixel P10. The pixel P10 is separately adjacent to a pixel P11 and a pixel P12. Therefore, in the pixel P11 and the pixel P12, green subpixels are above red subpixels, and blue subpixels are close to an upper edge of the pixel P10 and are adjacent to each other.

Based on the subpixel arrangement manner shown in FIG. 12E, each subpixel except a subpixel in an edge region of the display panel is close to another subpixel of a same color in the Y direction. Therefore, the openings of the FMMs for manufacturing the red subpixel, the green subpixel, and the blue subpixel may be greater than twice the size of the red subpixel, twice the size of the green subpixel, and twice the size of the blue subpixel respectively. In this way, manufacturing of an opening with a small size in the FMM can be avoided, and manufacturing costs are reduced. For example, for the pixels P10 to P13 in FIG. 12E, the blue subpixel in the pixel P10 and the blue subpixel in the pixel P12 are close to a boundary between the pixel P10 and the pixel P12, and the blue subpixel in the pixel P10 and the blue subpixel in the pixel P12 may be prepared by using an opening K7 in the FMM. The green subpixel in the pixel P10 and the green subpixel in the pixel P12 are close to the boundary between the pixel P10 and the pixel P12, and the blue subpixel in the pixel P10 and the green subpixel in the pixel P12 may be prepared by using an opening K8 in the FMM. The red subpixel in the pixel P11 and the red subpixel in the pixel P13 are close to a boundary between the pixel P11 and the pixel P13, and the red subpixel in the pixel P11 and the red subpixel in the pixel P13 may be prepared by using an opening K9 in the FMM.

In some embodiments, for the subpixel arrangement manner shown in FIG. 12E, locations of subpixels of different colors on the display panel may alternatively be exchanged. For example, a location of a red subpixel on the display panel is exchanged with a location of a blue subpixel on the display panel, and/or a location of a red subpixel on the display panel is exchanged with a location of a green subpixel on the display panel, and/or a location of a blue subpixel on the display panel is exchanged with a location of a green subpixel on the display panel. This is not limited herein.

In some embodiments, in the subpixel arrangement manners shown in FIG. 12C to FIG. 12E, at least some subpixels may be prepared by using an FMM whose opening size is twice (or more) that of the subpixels. When a minimum opening size of the FMM is fixed, a display panel with a smaller pixel size and a larger pixel density may be prepared. Therefore, the subpixel arrangement manners shown in FIG. 12C to FIG. 12E may be used for a display panel with a larger pixel density and/or a smaller pixel size.

Refer to FIG. 12F. In some embodiments, one subpixel may include four rectangular subpixels, namely, one red subpixel, two green subpixels, and one blue subpixel. In each pixel, the red subpixel and the blue subpixel are respectively arranged at two corners of a diagonal line of the pixel, and the two green subpixels are respectively disposed at two corners of the other diagonal line of the pixel.

Optionally, for the subpixel arrangement manner shown in FIG. 12F, the green subpixel may be rectangular, and the red subpixel and the blue subpixel may be square.

In some embodiments, for the subpixel arrangement manner shown in FIG. 12, locations of subpixels of different colors on the display panel may alternatively be exchanged. For example, a location of a red subpixel on the display panel is exchanged with a location of a blue subpixel on the display panel, or a location of a red subpixel is exchanged with a location of a green subpixel, or a location of a green subpixel is exchanged with a location of a blue subpixel.

It should be noted that the rectangular shape of the subpixels in FIG. 12A to FIG. 12F is merely an example. In some other embodiments, the shape of the subpixels may be another shape, for example, a circle, an ellipse, another polygon, an irregular shape, or the like without changing an arrangement manner of subpixels of different colors. This is not limited in embodiments of this application.

It should be noted that the colors of the subpixels in FIG. 12A to FIG. 12F are merely examples. In some other embodiments, one or more of the red subpixel, the blue subpixel, and the green subpixel may be replaced with a subpixel of another color. This is not limited in embodiments of this application.

Implementation 2: One pixel on the display panel includes a red subpixel, a green subpixel, a blue subpixel, and a cerulean subpixel, and a subpixel of each color includes a plurality of light-emitting units whose light-emitting colors are the same as the color of the subpixel.

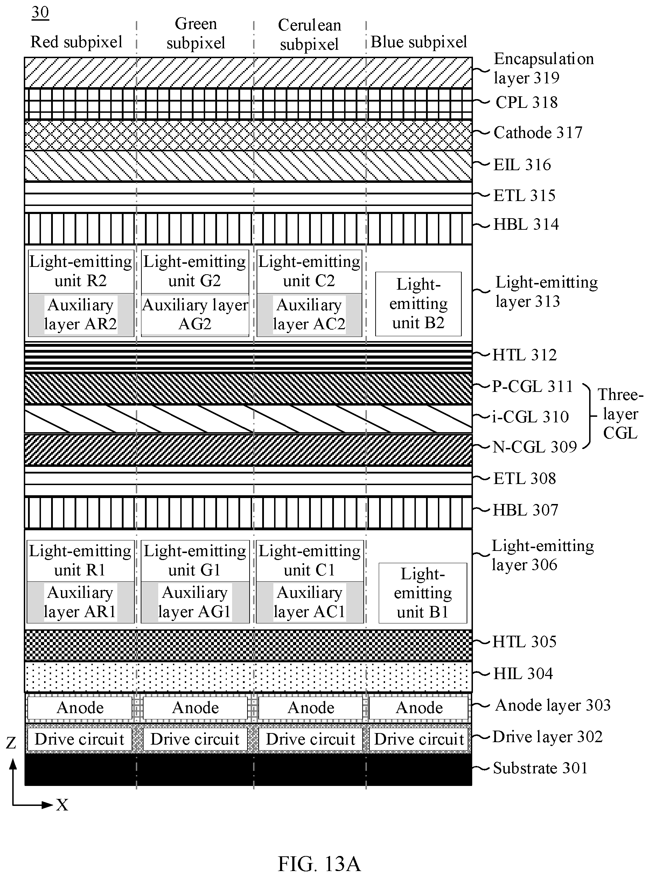

For example, FIG. 13A is a diagram of a structure of subpixels of different colors on a display panel according to some embodiments of this application.

As shown in FIG. 13A, a CGL in the display panel 30 is the foregoing three-layer CGL. Specifically, the display panel 30 includes a substrate 301, a drive layer 302, an anode 303, an HIL 304, an HTL 305, a light-emitting layer 306, an HBL 307, an ETL 308, an N-CGL 309, an i-CGL 310, a P-CGL 311, an HTL 312, a light-emitting layer 313, an HBL 314, an ETL 315, an EIL 316, a cathode 317, a CPL 318, and an encapsulation layer 319 that are sequentially stacked in a Z direction. The HBL 307 and the HBL 314 are optional. For functions and materials of the layers, refer to related content in the display panel 10. This is not limited herein.

For the red subpixel, the light-emitting layer 306 may include an auxiliary layer AR1 and a red light-emitting unit R1 that are sequentially stacked. The light-emitting layer 313 may include an auxiliary layer AR2 and a red light-emitting unit R2 that are sequentially stacked. The auxiliary layer AR1 is disposed on a side that is of the light-emitting layer 306 and that is close to the HTL 305, and the auxiliary layer AR2 is disposed on a side that is of the light-emitting layer 313 and that is close to the HTL 312.

For the green subpixel, the light-emitting layer 306 may include an auxiliary layer AG1 and a green light-emitting unit G1 that are sequentially stacked. The light-emitting layer 313 may include an auxiliary layer AG2 and a green light-emitting unit G2 that are sequentially stacked. The auxiliary layer AG1 is disposed on the side that is of the light-emitting layer 306 and that is close to the HTL 305, and the auxiliary layer AG2 is disposed on the side that is of the light-emitting layer 313 and that is close to the HTL 312.

For the cerulean subpixel, the light-emitting layer 306 may include an auxiliary layer AC1 and a cerulean light-emitting unit C1 that are sequentially stacked. The light-emitting layer 313 may include an auxiliary layer AC2 and a cerulean light-emitting unit C2 that are sequentially stacked. The auxiliary layer AC1 is disposed on the side that is of the light-emitting layer 306 and that is close to the HTL 305, and the auxiliary layer AC2 is disposed on the side that is of the light-emitting layer 313 and that is close to the HTL 312.

For the blue subpixel, the light-emitting layer 306 may include a blue light-emitting unit B1, and the light-emitting layer 313 may include a blue light-emitting unit B2.

For the display panel shown in FIG. 13A, the light-emitting layers may be prepared by using 11 FMMs. The 11 FMMs are respectively: four FMMs corresponding to light-emitting units of four colors in the light-emitting layer 306, three FMMs respectively corresponding to the auxiliary layer AR1, the auxiliary layer AG1, and the auxiliary layer AC1 in the light-emitting layer 313, and four FMMs respectively corresponding to light-emitting units of four colors in the light-emitting layer 2.

In other words, in the display panel 30 shown in FIG. 13A, an auxiliary layer is disposed between a light-emitting unit of the red subpixel, a light-emitting unit of the green subpixel, and a light-emitting unit of the cerulean subpixel at a light-emitting layer and a hole transport layer adjacent to the light-emitting layer. However, no auxiliary layer is disposed between a light-emitting unit of the blue subpixel at each light-emitting layer and a hole transport layer adjacent to the light-emitting layer.

It should be noted that, in some other embodiments, according to different manufacturing processes and different light-emitting requirements (for example, light-emitting luminance, color gamut, and light-emitting efficiency) on the display panel, a corresponding auxiliary layer may be added or reduced. Correspondingly, a quantity of FMMs required for preparing a light-emitting layer may be increased or reduced.

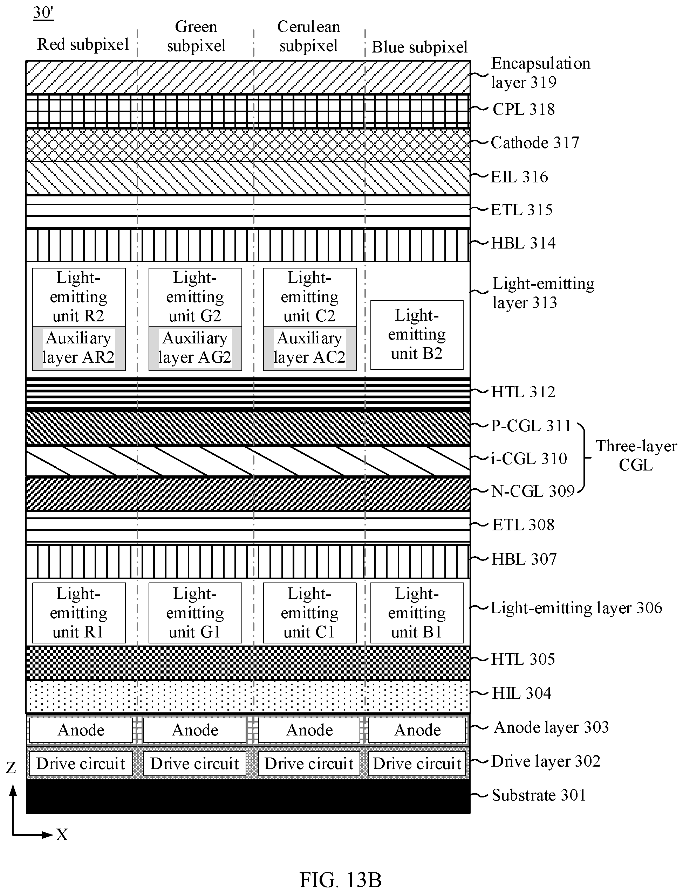

For example, refer to FIG. 13B. Compared to the display panel 30, in the display panel 30', no auxiliary layer is disposed between the HTL 305 and the light-emitting unit of the red subpixel, the light-emitting unit of the green subpixel, and the light-emitting unit of the cerulean subpixel at the light-emitting layer 305.

It should be noted that, in FIG. 13A and FIG. 13B, that no auxiliary layer is disposed between the light-emitting unit of the blue subpixel and the adjacent HTL is merely an example. In some other embodiments, no auxiliary layer may be disposed between light-emitting units of subpixels of one or more other colors and an adjacent HTL, or an auxiliary layer may be disposed between light-emitting units of subpixels of all colors and an adjacent HTL. This is not limited herein.

For example, in some embodiments, an auxiliary layer may be disposed between the HTL 305 and the light-emitting unit of the red subpixel, the light-emitting unit of the green subpixel, and the light-emitting unit of the blue subpixel at the light-emitting layer 306. An auxiliary layer may be disposed between the HTL 312 and the light-emitting unit of the red subpixel, the light-emitting unit of the green subpixel, and the light-emitting unit of the blue subpixel at the light-emitting layer 313. However, no auxiliary layer is disposed between the light-emitting unit of the blue subpixel and the adjacent HTL.

For another example, in some embodiments, an auxiliary layer may be disposed between the HTL 305 and the light-emitting unit of the red subpixel, the light-emitting unit of the cerulean subpixel, and the light-emitting unit of the blue subpixel at the light-emitting layer 306. An auxiliary layer may be disposed between the HTL 312 and the light-emitting unit of the red subpixel, the light-emitting unit of the cerulean subpixel, and the light-emitting unit of the blue subpixel at the light-emitting layer 313. However, no auxiliary layer is disposed between the light-emitting unit of the green subpixel and the adjacent HTL.

For still another example, in some embodiments, an auxiliary layer may be disposed between the HTL 305 and the light-emitting unit of the green subpixel, the light-emitting unit of the cerulean subpixel, and the light-emitting unit of the blue subpixel at the light-emitting layer 306. An auxiliary layer may be disposed between the HTL 312 and the light-emitting unit of the green subpixel, the light-emitting unit of the cerulean subpixel, and the light-emitting unit of the blue subpixel at the light-emitting layer 313. However, no auxiliary layer is disposed between the light-emitting unit of the red subpixel and the adjacent HTL.

Corresponding to the cases shown in FIG. 13A and FIG. 13B, shapes, arrangement orders, and quantities of subpixels may be arranged in a plurality of different manners.

It should be noted that, in some other embodiments, one or more of the red subpixel, the green subpixel, the blue subpixel, and the cerulean subpixel on the display panel 30/30' may alternatively be replaced with a subpixel of another color. This is not limited herein. For example, the cerulean subpixel may be replaced with a subpixel that emits white light, a cyan subpixel, or the like.

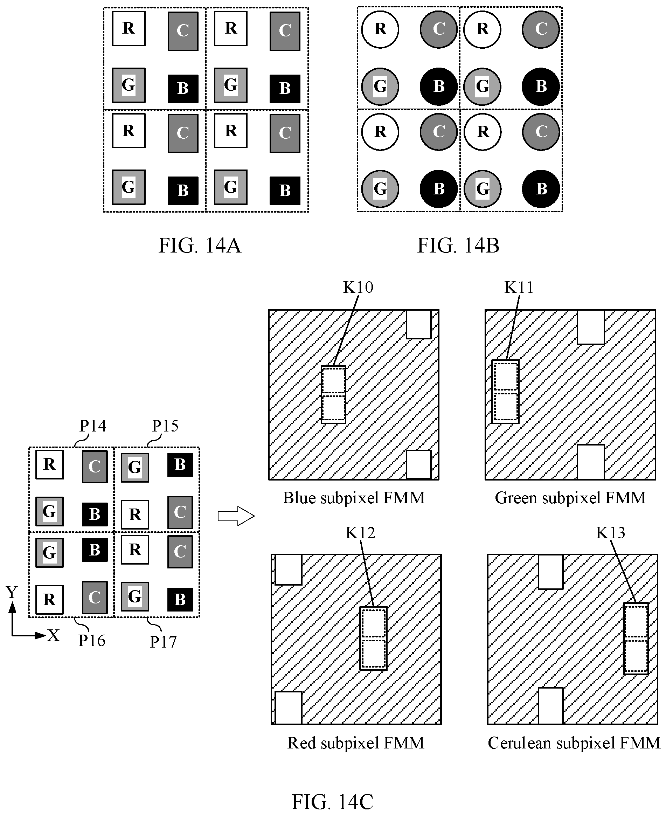

For example, FIG. 14A to FIG. 14E are diagrams of a plurality of subpixel arrangement manners.

Refer to FIG. 14A, one pixel may include four rectangular subpixels, namely, a red subpixel, a green subpixel, a blue subpixel, and a cerulean subpixel. In each pixel, an arrangement manner of the red subpixel, the green subpixel, the blue subpixel, and the cerulean subpixel is the same. For example, the red subpixel, the green subpixel, the cerulean subpixel, and the blue subpixel may be respectively arranged in an upper left corner, a lower left corner, an upper right corner, and a lower right corner of one pixel.

It should be noted that, corresponding to the case shown in FIG. 14A, when it is ensured that arrangement of the subpixels in each pixel is the same, locations of the subpixels may be exchanged.

Refer to FIG. 14B, one pixel may include four circular subpixels, namely, a red subpixel, a green subpixel, a blue subpixel, and a cerulean subpixel. In each pixel, a distribution manner of the red subpixel, the green subpixel, the blue subpixel, and the cerulean subpixel is the same. For example, the red subpixel, the green subpixel, the cerulean subpixel, and the blue subpixel may be respectively arranged in an upper left corner, a lower left corner, an upper right corner, and a lower right corner of one pixel.

It should be noted that, corresponding to the case shown in FIG. 14B, when it is ensured that arrangement of the subpixels in each pixel is the same, locations of the subpixels may be exchanged.

For example, one pixel may include four rectangular subpixels, namely, a red subpixel, a green subpixel, a blue subpixel, and a cerulean subpixel. The four subpixels in the pixel are respectively disposed at four corners of the pixel. Arrangement manners of subpixels in two adjacent pixels are mirrored relative to the X direction. For example, subpixels of four colors in each pixel may be arranged into two rows and two columns, where a subpixel of a first color and a subpixel of a second color are arranged in one column, and a subpixel of a third color and a subpixel of a fourth color are arranged in the other column. For example, the subpixel of the first color and the subpixel of the second color are arranged at two adjacent corners in the Y direction, and the subpixel of the third color and the subpixel of the fourth color are arranged at the other two adjacent corners in the Y direction. In this way, the subpixels of the first color and the subpixels of the second color in the two adjacent pixels are arranged in a reverse order in the Y direction, and the subpixels of the third color and the subpixels of the fourth color in the two adjacent pixels are arranged in a reverse order in the Y direction.

For example, in the case shown in FIG. 14C, the subpixels of the first color to the fourth color may be a red subpixel, a green subpixel, a cerulean subpixel, and a blue subpixel respectively. Each pixel has two columns of subpixels. The red subpixel and the cerulean subpixel are arranged in a same row, and the green subpixel and the blue subpixel are arranged in a same row. In a pixel P14, the red subpixel and the cerulean subpixel are arranged in the first row, and the green subpixel and the blue subpixel are arranged in the second row. In a pixel P15 and a pixel P16 that are adjacent to the pixel P14, the red subpixel and the cerulean subpixel are arranged in the second row, and the green subpixel and the blue subpixel are arranged in the first row. A pixel P17 is separately adjacent to the pixel P15 and the pixel P16. Color arrangement manners of the subpixels in the adjacent pixel P15 and pixel P16 are the same. In the pixel 17, the red subpixel and the cerulean subpixel are arranged in the first row, and the green subpixel and the blue subpixel are arranged in the second row.

It should be noted that, the subpixel of the first color to the subpixel of the fourth color may be any one of full arrangements of the red subpixel, the green subpixel, the blue subpixel, and the cerulean subpixel (there are totally 4!=24 arrangement manners for full arrangements of the subpixels of the four colors). For example, the subpixel of the first color to the subpixel of the fourth color may be respectively a red subpixel, a green subpixel, a blue subpixel, and a cerulean subpixel, or may be respectively a green subpixel, a red subpixel, a blue subpixel, and a cerulean subpixel, or may be respectively a green subpixel, a red subpixel, a blue subpixel, and a cerulean subpixel, ... and so on. When a size of a pixel is fixed, a larger quantity of subpixels in the pixel indicates a smaller size of a single subpixel, and a smaller size of an opening in an FMM used for preparing a light-emitting unit. Based on the arrangement manner shown in FIG. 14C, each subpixel except a subpixel at an edge of the display panel has an adjacent subpixel in the Y direction that is of a same color as the subpixel. Therefore, each subpixel and a subpixel that is adjacent to the subpixel in the Y direction and that is of a same color may be prepared by using an opening in the FMM. In other words, the opening in the FMM may be twice the size of the subpixel, so that use of an FMM with a smaller opening may be avoided, thereby helping to save costs.

For example, for the pixels P14 to P17 in FIG. 14C, the blue subpixel in the pixel P14 and the blue subpixel in the pixel P16 are close to a boundary between the pixel P14 and the pixel P16, and the blue subpixel in the pixel P14 and the blue subpixel in the pixel P16 may be prepared by using an opening K10 in the FMM. The green subpixel in the pixel P14 and the green subpixel in the pixel P16 are close to the boundary between the pixel P14 and the pixel P16, and the green subpixel in the pixel P14 and the green subpixel in the pixel P16 may be prepared by using an opening K11 in the FMM. The red subpixel in the pixel P15 and the red subpixel in the pixel P17 are close to a boundary between the pixel P15 and the pixel P17, and the red subpixel in the pixel P15 and the red subpixel in the pixel P17 may be prepared by using an opening K12 in the FMM. The cerulean subpixel in the pixel P15 and the cerulean subpixel in the pixel P17 are close to the boundary between the pixel P15 and the pixel P17, and the cerulean subpixel in the pixel P15 and the cerulean subpixel in the pixel P17 may be prepared by using an opening K13 in the FMM.

In addition, when a minimum size of an opening that can be manufactured on the FMM is fixed, a pixel size of the display panel that uses the pixel arrangement manner shown in FIG. 14C may be smaller. For example, if the minimum size of the opening that can be manufactured on the FMM is 5 µm, a size of a single subpixel may be 2.5 µm when the display panel that uses the pixel arrangement manner shown in FIG. 14C is manufactured, and a size of a single subpixel is 5 µm when the display panel that uses the pixel arrangement manner shown in FIG. 14A or FIG. 14B is manufactured.

For example, one pixel may include four rectangular subpixels, namely, a red subpixel, a green subpixel, a blue subpixel, and a cerulean subpixel. The four subpixels in the pixel are respectively disposed at four corners of the pixel. Arrangement manners of subpixels in two adjacent pixels are mirrored relative to the Y direction. For example, subpixels of four colors in each pixel may be arranged into two rows and two columns, where a subpixel of a first color and a subpixel of a second color are arranged in one column, and a subpixel of a third color and a subpixel of a fourth color are arranged in the other column. For example, the subpixel of the first color and the subpixel of the second color are arranged at two adjacent corners in the X direction, and the subpixel of the third color and the subpixel of the fourth color are arranged at the other two adjacent corners in the X direction. In this way, the subpixels of the first color and the subpixels of the second color in the two adjacent pixels are arranged in a reverse order in the X direction, and the subpixels of the third color and the subpixels of the fourth color in the two adjacent pixels are arranged in a reverse order in the X direction.

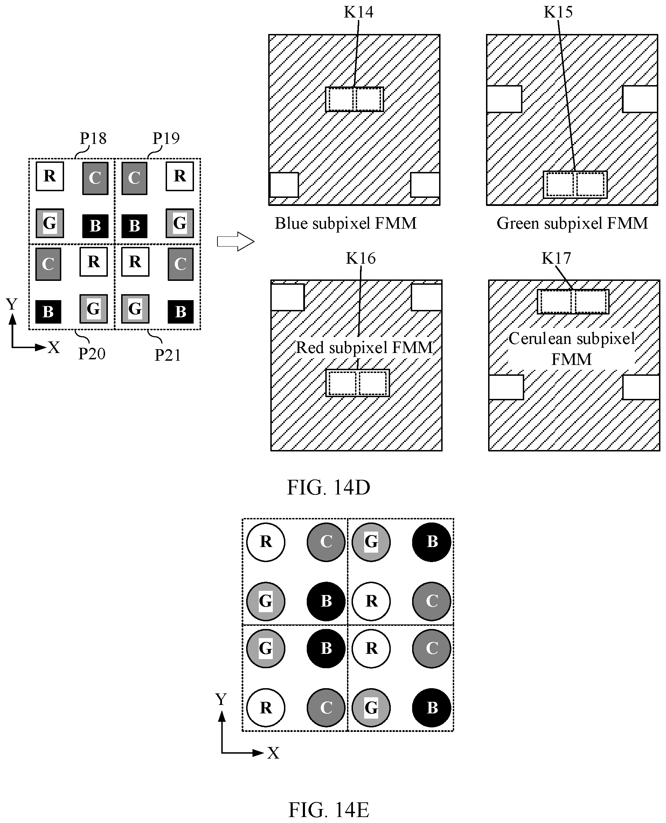

For example, in the case shown in FIG. 14D, the subpixels of the first color to the fourth color may be a red subpixel, a cerulean subpixel, a green subpixel, and a blue subpixel respectively. Each pixel has two rows and two columns of subpixels. The red subpixel and the green subpixel are arranged in a same column, and the cerulean subpixel and the blue subpixel are arranged in a same column. In a pixel P18, the red subpixel and the green subpixel are arranged in the first column, and the cerulean subpixel and the blue subpixel are arranged in the second column. In a pixel P19 and a pixel P20 that are adjacent to the pixel P18, the red subpixel and the green subpixel are arranged in the second column, and the cerulean subpixel and the blue subpixel are arranged in the first column. A pixel P21 is separately adjacent to the pixel P20 and the pixel P18. Color arrangement manners of the subpixels in the adjacent pixel P20 and pixel P18 are the same. In the pixel P21, the red subpixel and the green subpixel are arranged in the first column, and the cerulean subpixel and the blue subpixel are arranged in the second column.

It should be noted that, the subpixel of the first color to the subpixel of the fourth color may be any one of full arrangements of the red subpixel, the cerulean subpixel, the blue subpixel, and the green subpixel (there are totally 4!=24 arrangement manners for full arrangements of the subpixels of the four colors). For example, the subpixel of the first color to the subpixel of the fourth color may be respectively a red subpixel, a cerulean subpixel, a blue subpixel, and a green subpixel, or may be respectively a cerulean subpixel, a red subpixel, a blue subpixel, and a green subpixel, or a cerulean subpixel, a red subpixel, a blue subpixel, and a green subpixel, ....

When a size of a pixel is fixed, a larger quantity of subpixels in the pixel indicates a smaller size of a single subpixel, and a smaller size of an opening in an FMM used for preparing a light-emitting unit. Based on the arrangement manner shown in FIG. 14D, each subpixel except a subpixel at an edge of the display panel has an adjacent subpixel in the X direction that is of a same color as the subpixel. Therefore, each subpixel and a subpixel that is adjacent to the subpixel in the X direction and that is of a same color may be prepared by using an opening in the FMM. In other words, the opening in the FMM may be twice the size of the subpixel, so that use of an FMM with a smaller opening may be avoided, thereby helping to save costs.

For example, for the pixels P18 to P21 in FIG. 14D, the blue subpixel in the pixel P18 and the blue subpixel in the pixel P19 are close to a boundary between the pixel P18 and the pixel P19, and the blue subpixel in the pixel P18 and the blue subpixel in the pixel P19 may be prepared by using an opening K14 in the FMM. The green subpixel in the pixel P20 and the green subpixel in the pixel P21 are close to a boundary between the pixel P20 and the pixel P21, and the green subpixel in the pixel P20 and the green subpixel in the pixel P21 may be prepared by using an opening K15 in the FMM. The cerulean subpixel in the pixel P18 and the cerulean subpixel in the pixel P19 are close to the boundary between the pixel P18 and the pixel P19, and the cerulean subpixel in the pixel P18 and the cerulean subpixel in the pixel P19 may be prepared by using an opening K17 in the FMM. The red subpixel in the pixel P20 and the red subpixel in the pixel P21 are close to the boundary between the pixel P20 and the pixel P21, and the red subpixel in the pixel P20 and the red subpixel in the pixel P21 may be prepared by using an opening K16 in the FMM.

It should be noted that the shape of the subpixels in FIG. 14A to FIG. 14D is merely an example. In some other embodiments, the shape of the subpixels may be another shape, for example, a circle, an ellipse, another polygon, an irregular shape, or the like. This is not limited in embodiments of this application.

For example, in the subpixel arrangement manner shown in FIG. 14E, an arrangement manner of subpixels of each color is the same as that in FIG. 14C. The difference lies in that the shape of each subpixel is a circle.

In some embodiments, in the subpixel arrangement manners shown in FIG. 14C and FIG. 14E, at least some subpixels may be prepared by using an FMM whose opening size is twice (or more) that of the subpixels. When a minimum opening size of the FMM is fixed, a display panel with a smaller pixel size and a larger pixel density may be prepared. Therefore, the subpixel arrangement manners shown in FIG. 14C and FIG. 14E may be used for a display panel with a larger pixel density and/or a smaller pixel size.

It should be noted that the colors of the subpixels in FIG. 14A to FIG. 14E are merely examples. In some other embodiments, one or more of the red subpixel, the blue subpixel, the green subpixel, and the cerulean subpixel may be replaced with a subpixel of another color. This is not limited in embodiments of this application.

Implementation 3: One pixel on the display panel includes a red subpixel, a green subpixel, and a blue subpixel, and a subpixel of each color includes a plurality of blue light-emitting units. In this display panel, a color change layer and a color filter layer may be superimposed on the encapsulation layer to convert blue light into a color of a corresponding subpixel.

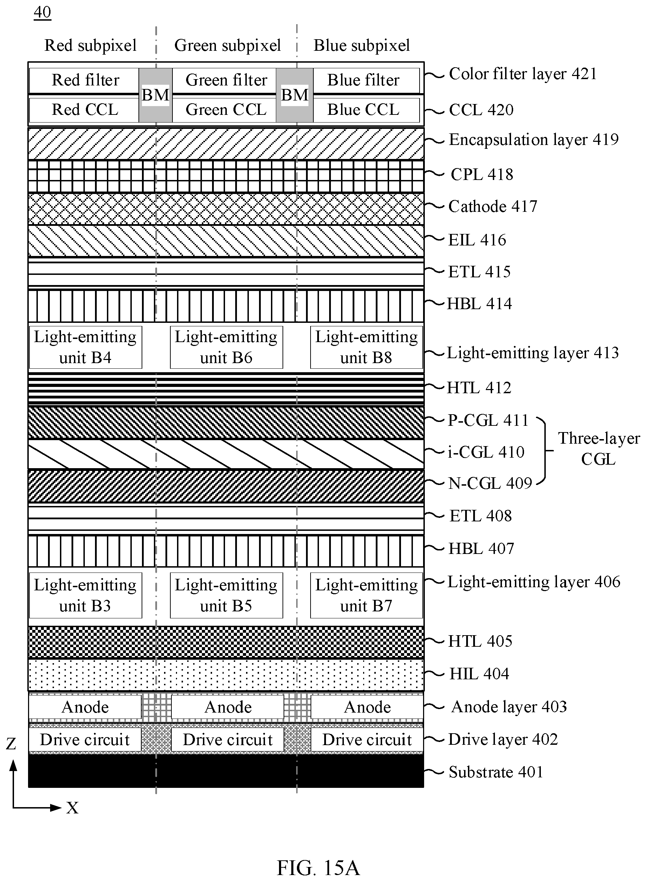

As shown in FIG. 15A, a CGL in a display panel 40 is the foregoing three-layer CGL. Specifically, the display panel 40 includes a substrate 401, a drive layer 402, an anode 403, an HIL 404, an HTL 405, a light-emitting layer 406, an HBL 407, an ETL 408, an N-CGL 409, an i-CGL 410, a P-CGL 411, an HTL 412, a light-emitting layer 413, an HBL 414, an ETL 415, an EIL 416, a cathode 417, a CPL 418, an encapsulation layer 419, a CCL 420, and a color filter layer 421 that are sequentially stacked in a Z direction. The HBL 407 and the HBL 414 are optional. For functions and materials of the layers, refer to related content in the display panel 10. This is not limited herein.

For the red subpixel, the light-emitting layer 406 may include a blue light-emitting unit B3, and the light-emitting layer 413 may include a blue light-emitting unit B4. The CCL 420 may be a red CCL that is configured to convert blue light into red light. The color filter layer 421 may include a red filter (or a red filter film) that is configured to filter out light of a color other than red light. In other words, composite light (which may alternatively be monochromatic light when the blue light-emitting unit B3 and the blue light-emitting unit B4 emit light of a single color) formed by combining light emitted by the blue light-emitting unit B3 and the blue light-emitting unit B4 may be converted into red light at the color filter layer.

For the green subpixel, the light-emitting layer 406 may include a blue light-emitting unit B5, and the light-emitting layer 413 may include a blue light-emitting unit B6. The CCL 420 may be a green CCL that is configured to convert blue light into green light. The color filter layer may include a green filter (or a green filter film) that is configured to filter out light of a color other than green light. In other words, composite light (which may alternatively be monochromatic light when the blue light-emitting unit B5 and the blue light-emitting unit B6 emit light of a single color) formed by combining light emitted by the blue light-emitting unit B5 and the blue light-emitting unit B6 may be converted into green light at the color filter layer.

For the blue subpixel, the light-emitting layer 406 may include a blue light-emitting unit B7, and the light-emitting layer 413 may include a blue light-emitting unit B9. The CCL 420 may be a blue CCL that is configured to convert light emitted by the blue light-emitting unit B7 and the blue light-emitting unit B9 into blue light. The color filter layer 421 may include a blue filter (or a blue filter film) that is configured to filter out light of a color other than blue light.

In some other embodiments, for the display panel shown in FIG. 15A, the blue subpixel may not have a blue color change layer superimposed on the encapsulation layer, but has the color filter layer directly superimposed on the encapsulation layer 419.

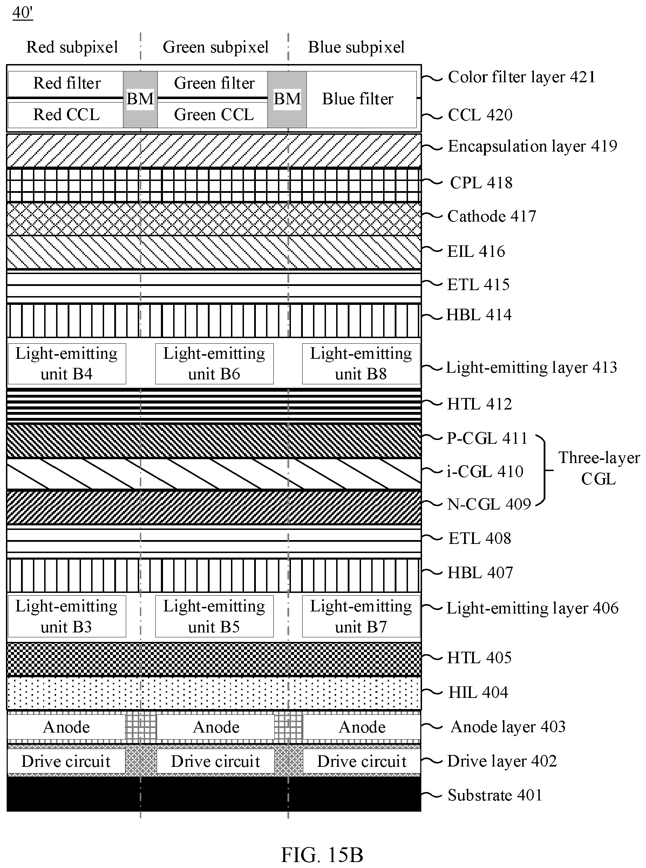

For example, FIG. 15B is a diagram of a display panel 40'. As shown in FIG. 15B, compared with the display panel 40', the blue subpixel has a blue filter (or a filter film) directly stacked above the encapsulation layer 419, instead of having a blue CCL superimposed first and a blue filter layer superimposed next.

For the display panels shown in FIG. 15A and FIG. 15B, for subpixel arrangement manners, refer to the foregoing embodiments in FIG. 12A to FIG. 12F. Details are not described herein again.

Implementation 4: One pixel on the display panel includes a red subpixel, a green subpixel, and a blue subpixel, and a subpixel of each color includes a blue light-emitting unit and a white light-emitting unit. In this display panel, a color change layer and a color filter layer may be superimposed on the encapsulation layer to convert blue light into a color of a corresponding subpixel.

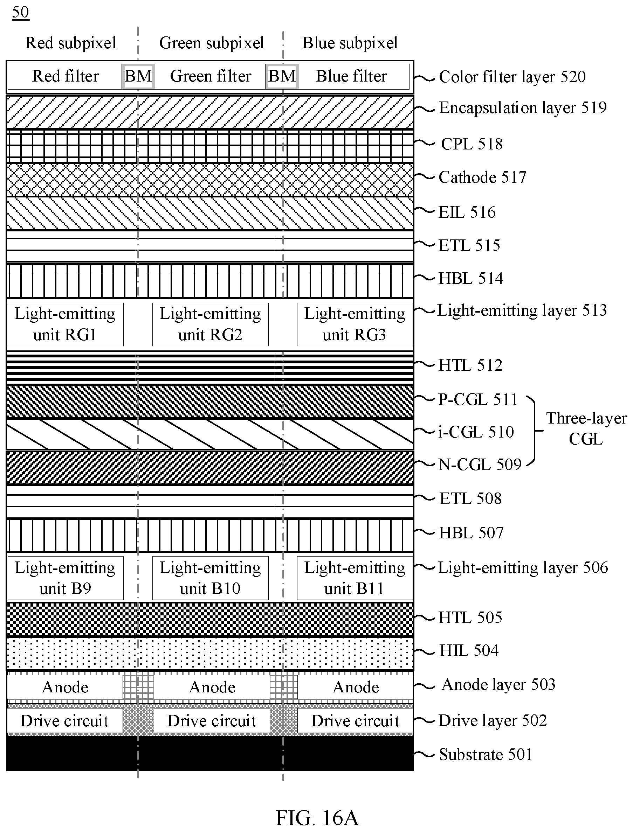

As shown in FIG. 16A, a CGL in a display panel 50 is the foregoing three-layer CGL. Specifically, the display panel 50 includes a substrate 501, a drive layer 502, an anode 503, an HIL 504, an HTL 505, a light-emitting layer 506, an HBL 507, an ETL 508, an N-CGL 509, an i-CGL 510, a P-CGL 511, an HTL 512, a light-emitting layer 513, an HBL 514, an ETL 515, an EIL 516, a cathode 517, a CPL 518, an encapsulation layer 519, and a color filter layer 520 that are sequentially stacked in a Z direction. The HBL 407 and the HBL 414 are optional. For functions and materials of the layers, refer to related content in the display panel 10. This is not limited herein.

For the red subpixel, the light-emitting layer 506 may include a blue light-emitting unit B9, and the light-emitting layer 513 may include a white light (or may be other composite light) light-emitting unit (for example, a composite light-emitting unit that emits red light and green light, or may be a composite light-emitting unit that emits other composite light) RG1. The color filter layer 520 may include a red filter (or a red filter film) that is configured to filter out light of a color other than red light. In other words, composite light formed by combining light emitted by the blue light-emitting unit B9 and the white light-emitting unit RG1 may be converted into red light at the color filter layer.

For the green subpixel, the light-emitting layer 506 may include a blue light-emitting unit B10, and the light-emitting layer 513 may include a white light-emitting unit RG2. The color filter layer 520 may include a green filter (or a green filter film) that is configured to filter out light of a color other than green light. In other words, composite light formed by combining light emitted by the blue light-emitting unit B10 and the white light-emitting unit RG2 may be converted into green light at the color filter layer.

For the blue subpixel, the light-emitting layer 506 may include a blue light-emitting unit B11, and the light-emitting layer 513 may include a white light-emitting unit RG3. The color filter layer may include a blue filter (or a blue filter film) that is configured to filter out light of a color other than blue light. In other words, composite light formed by combining light emitted by the blue light-emitting unit B11 and the white light-emitting unit RG3 may be converted into blue light at the color filter layer.

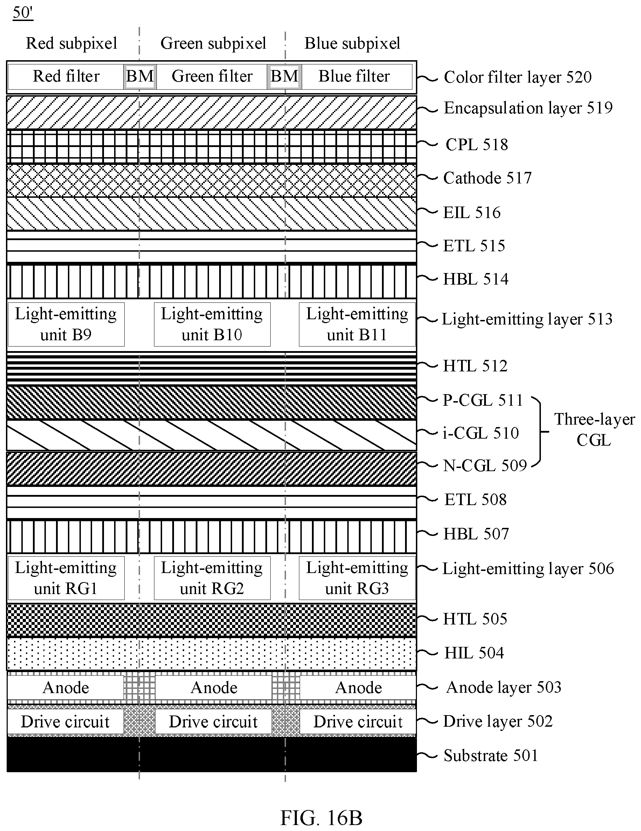

In some other embodiments, light-emitting units of the light-emitting layer 506 and the light-emitting layer 513 in the display panel 50 may interact with each other. For example, FIG. 16B is a diagram of a structure of a display panel 50' according to some embodiments of this application. Compared with the display panel 50, in the display panel 50', white light-emitting units corresponding to each subpixel are disposed in the light-emitting layer 506, and blue light-emitting units corresponding to each subpixel are disposed in the light-emitting layer 513.

For the display panels shown in FIG. 16A and FIG. 16B, for subpixel arrangement manners, refer to the foregoing embodiments in FIG. 12A to FIG. 12F. Details are not described herein again.

In some embodiments, for the display panels shown in FIG. 16A and FIG. 16B, the blue light-emitting unit may be replaced with a light-emitting unit of another color, and the white light-emitting unit may also be replaced with a light-emitting unit of another color. This is not limited herein.

An embodiment of this application further provides a display panel. One pixel in the display panel includes subpixels of four colors, and one subpixel includes one light-emitting unit.

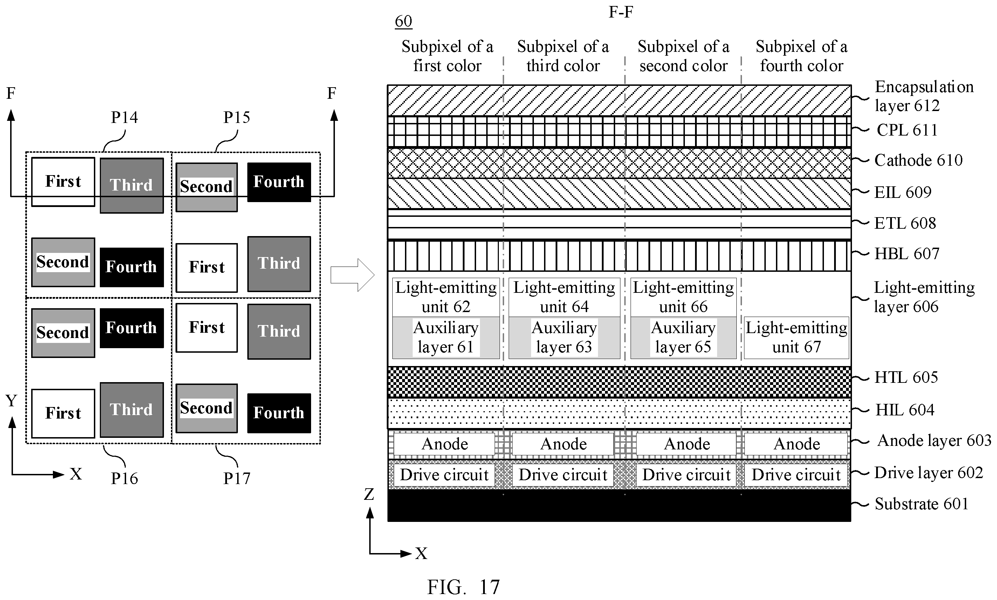

For example, FIG. 17 is a diagram of a pixel arrangement and an F-F cross section of a display panel 60 according to some embodiments of this application.

Refer to FIG. 17. In the display panel 60, four subpixels in one pixel are respectively disposed at four corners of the pixel, and arrangement manners of subpixels in two adjacent pixels are mirrored relative to the X direction. For example, subpixels of four colors in each pixel may be arranged into two rows and two columns, where a subpixel of a first color and a subpixel of a second color are arranged in one column, and a subpixel of a third color and a subpixel of a fourth color are arranged in the other column. For example, the subpixel of the first color and the subpixel of the second color are arranged at two adjacent corners in the Y direction, and the subpixel of the third color and the subpixel of the fourth color are arranged at the other two adjacent corners in the Y direction. In this way, the subpixels of the first color and the subpixels of the second color in the two adjacent pixels are arranged in a reverse order in the Y direction, and the subpixels of the third color and the subpixels of the fourth color in the two adjacent pixels are arranged in a reverse order in the Y direction. For a specific arrangement manner, refer to the embodiment shown in FIG. 14C. Details are not described herein again.

Refer to FIG. 17. The display panel 60 includes a substrate 601, a drive layer 602, an anode 603, an HIL 604, an HTL 605, a light-emitting layer 606, an HBL 607, an ETL 608, an EIL 609, a cathode 610, a CPL 611, and an encapsulation layer 612 that are sequentially stacked in a Z direction. The HBL 607 is optional. For functions and materials of the layers, refer to related content in the display panel 10. This is not limited herein.

For the subpixel of the first color, the light-emitting layer 606 may include an auxiliary layer 61 and a light-emitting unit 62 of the first color that are sequentially stacked, and the auxiliary layer 61 is disposed on a side that is of the light-emitting layer 606 and that is close to the HTL 605.

For the subpixel of the second color, the light-emitting layer 606 may include an auxiliary layer 63 and a light-emitting unit 64 of the second color that are sequentially stacked, and the auxiliary layer 63 is disposed on the side that is of the light-emitting layer 606 and that is close to the HTL 605.

For the subpixel of the third color, the light-emitting layer 606 may include an auxiliary layer 65 and a light-emitting unit 66 of the third color that are sequentially stacked, and the auxiliary layer 65 is disposed on the side that is of the light-emitting layer 606 and that is close to the HTL 605.

For the subpixel of the fourth color, the light-emitting layer 606 may include a light-emitting unit 67.

In some embodiments, the auxiliary layer 61, the auxiliary layer 63, and the auxiliary layer 65 are optional.

In some embodiments, an auxiliary layer may alternatively be disposed between the light-emitting unit 67 and the HTL 605.

It should be noted that, in some other embodiments, a shape of the subpixels in the display panel 60 may be a rectangle, a circle, an ellipse, another polygon, an irregular shape, or the like.

In some embodiments, the subpixel of the first color to the subpixel of the fourth color may be any one of full arrangements of subpixels of four colors (for example, the red subpixel, the green subpixel, the blue subpixel, and the cerulean subpixel) (there are totally 4!=24 arrangement manners for full arrangements of the subpixels of the four colors).

In the display panels provided in the foregoing embodiments, crosstalk between subpixels can be reduced or even avoided without adding an isolation pillar or another isolation structure. No isolation pillar or another isolation structure is disposed, so that a region between anodes in the anode layer is of a flat structure, and a surface of the region is continuous without bulges or grooves.

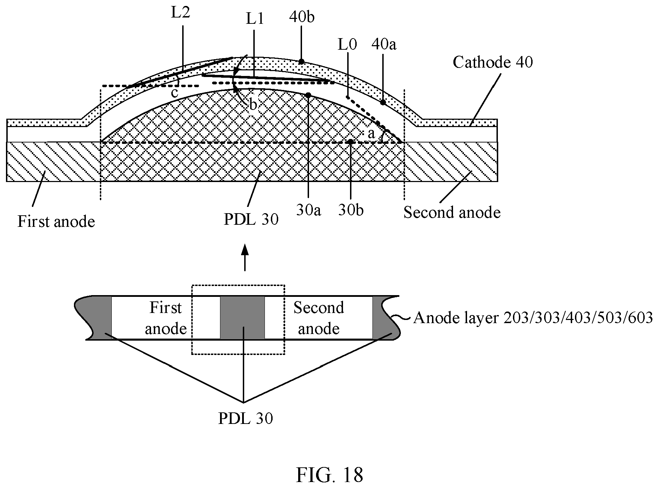

For example, FIG. 18 is a diagram of a structure of a PDL 30 and a first anode and a second anode that are adjacent to each other in the foregoing anode layer 203/303/403/503/603 according to some embodiments of this application.

As shown in FIG. 18, the PDL 30 between the first anode and the second anode may be in a shape of a water droplet, and a slope angle a of the PDL 30 may be defined: A tangent L0 of an arc surface 30a is made at an intersection point of the arc surface 30a of the PDL and a top surface 30b of the anodes, and an acute angle formed by the tangent L0 and the top surface 30b is referred to as the slope angle a. For a portion of the cathode 40 (for example, the cathode 217, the cathode 317, the cathode 417, the cathode 517, and the cathode 610) located between the first anode and the second anode that are adjacent to each other: An acute angle formed by the top surface 30b and a connection line between any two points within a surface 40a that is of the cathode 40 and that faces the PDL 30 is less than or equal to the slope angle a. For example, an acute angle b formed by a connection line L1 and the top surface 30b is less than the slope angle a. An acute angle formed by the top surface 30b and a connection line between any two points within a surface 40b that is of the cathode 40 and that is opposite to the PDL 30 is less than or equal to the slope angle a. For example, an acute angle c formed by a connection line L2 and the top surface 30b is less than the slope angle a. FIG. 18 shows only a case in which the acute angle formed by the connection line and the top surface 30b is less than the slope angle a. It is easy to understand that there is such a connection line, and an acute angle formed by the connection line and the top surface 31b is equal to the slope angle a.

It should be noted that the first anode and the second anode may be anodes of different subpixels in a same pixel, or may be anodes of adjacent subpixels in different pixels. This is not limited herein. For example, in FIG. 12C, the anode of the red subpixel and the anode of the green subpixel in the pixel P2 may be respectively the first anode and the second anode, and the anode of the green subpixel in the pixel P2 and the anode of the red subpixel in the pixel P4 may be respectively the first anode and the second anode. For another example, in FIG. 14C, when the anode of the blue subpixel in the pixel P14 is the first anode, the second anode may be the anode of the cerulean subpixel or the anode of the green subpixel in the pixel P4, or the anode of the red subpixel in the pixel P15, or the anode of a blue subpixel in the pixel P16.

It should be noted that the HIL, the HTL, the light-emitting layer, the HBL, the ETL, and the EIT are disposed between the anode layer 203/303/403/503/603 and the cathode 40. For details, refer to the foregoing embodiments in FIG. 4 to FIG. 17. Details are not described herein again.

It should be noted that the PDL shown in FIG. 18 is merely an example. In some other embodiments, a shape of the PDL may alternatively be another shape. This is not limited herein.

An embodiment of this application further provides an electronic device. The electronic device includes any display panel provided in the foregoing embodiments. The electronic device may be any electronic device that can display a picture, including but not limited to a mobile phone (for example, a bar-type mobile phone, a foldable mobile phone, a rollable mobile phone, or the like), a tablet computer, a notebook computer (including a foldable notebook computer), a smart screen, a desktop display, a smart wearable product (for example, a smartwatch, a smart band, or the like), a mixed reality (mixed reality, MR) device, a virtual reality (virtual reality, VR) device, an augmented reality (augmented reality, AR) device, an in-vehicle device (for example, in-vehicle infotainment or an in-vehicle navigator), a home electronic product such as a smart door lock, a television, a refrigerator, rechargeable small household appliances (for example, a soybean milk maker or a vacuum cleaning robot), or the like.

In some embodiments, the electronic device includes a mechanical part and a display fastened to the mechanical part. The display may include a cover plate and a display panel. The cover plate is attached to the display panel. The display panel may be the display panel provided in the foregoing embodiments.

In the descriptions of embodiments of this application, unless otherwise specified, "a plurality of (layers)" means two (layers) or more.

Terms such as "first" and "second" are used only for description purposes, and cannot be understood as an indication or implication of relative importance or an implicit indication of a quantity of indicated technical features. A feature limited by "first" or "second" may explicitly or implicitly include one or more features.

"Connection" should be understood in a broad sense. For example, "connection" may be a detachable connection, a nondetachable connection, a direct connection, or an indirect connection through an intermediate medium. "Fastening" should also be understood in a broad sense. For example, "fastening" may be direct fastening or indirect fastening through an intermediate medium.

The orientation terms mentioned in embodiments of this application, for example, "up", "down", "left", "right", "upper left", "lower left", "upper right", "lower right", are merely directions with reference to the accompanying drawings. The orientation terms are used to better and more clearly describe and understand embodiments of this application, instead of explicitly or implicitly indicating that an apparatus or element needs to have a specific orientation and be constructed and operated in a specific orientation, or the like, and cannot be understood as limitations on embodiments of this application.

In the descriptions of embodiments of this application, unless otherwise specified, "and/or" is merely an association relationship for describing an associated object, and indicates that three relationships may exist. For example, A and/or B may represent the following three cases: Only A exists alone, both A and B exist, and only B exists.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A display panel, comprising an anode layer, a plurality of light-emitting layers, a cathode, and a plurality of charge generation layers, wherein
the plurality of light-emitting layers and the plurality of charge generation layers are disposed between the anode layer and the cathode, and one charge generation layer is disposed between every two light-emitting layers;
the charge generation layer comprises an N-type charge generation layer, an insertion layer, and a P-type charge generation layer that are sequentially stacked in a first direction, wherein the first direction is a direction in which the anode layer points to the cathode;
a sheet resistance of the charge generation layer in a direction perpendicular to the first direction is greater than 1 GΩ/□; and
corresponding to the insertion layer being made of an organic material, a lowest unoccupied molecular orbital energy level of the organic material is lower than or equal to -3.5 eV; or
corresponding to the insertion layer being made of an inorganic material, a work function of the inorganic material is higher than or equal to 3.5 eV.

2. The display panel according to claim 1, wherein a thickness of the insertion layer is less than or equal to 15 nm.

3. The display panel according to claim 1, wherein a thickness of the insertion layer is less than or equal to 5 nm.

4. The display panel according to claim 1, wherein a Fermi level of the insertion layer is lower than a Fermi level of a host material of the P-type charge generation layer.

5. The display panel according to claim 1, wherein a material of the N-type charge generation layer comprises a host material and a guest material, and a concentration of the guest material ∈ (0%, 10%].

6. The display panel according to claim 1, wherein the display panel further comprises a pixel definition layer, the anode layer comprises a plurality of anodes, and any two adjacent anodes in the plurality of anodes are isolated by the pixel definition layer; and
corresponding to a first anode and a second anode that are adjacent to each other in the plurality of anodes:
the first anode has a top surface facing the cathode layer;
a portion that is of the pixel definition layer and that is located between the first anode and the second anode has a slope angle;
an acute angle formed by the top surface and a connection line between any two points within a surface that is of the cathode and that faces the pixel definition layer is less than or equal to the slope angle; and
an acute angle formed by the top surface and a connection line between any two points within a surface that is of the cathode and that is away from the pixel definition layer is less than or equal to the slope angle.

7. The display panel according to claim 1, wherein the display panel further comprises a hole injection layer, an electron injection layer, a plurality of hole transport layers, a plurality of electron transport layers, and a substrate, wherein
the hole injection layer and one hole transport layer are sequentially stacked in the first direction between the anode layer and a first light-emitting layer that is in the plurality of light-emitting layers and that is closest to the anode layer;
one electron transport layer and the electron injection layer are sequentially stacked in the first direction between the cathode and a second light-emitting layer that is in the plurality of light-emitting layers and that is closest to the cathode;
one electron transport layer and one hole transport layer are disposed between every two light-emitting layers, and the electron transport layer, the insertion layer, and the hole transport layer between every two light-emitting layers are sequentially stacked in the first direction; and
the substrate is disposed on a side that is of the anode layer and that is away from the cathode layer.

8. The display panel according to claim 7, wherein the display panel further comprises a plurality of hole blocking layers, and one hole blocking layer is disposed between each light-emitting layer and an adjacent electron transport layer.

9. The display panel according to any one of claims 1 to 8, wherein the display panel comprises a plurality of pixels arranged in an array, each pixel comprises four subpixels of different colors, and four subpixels in one pixel are arranged in two rows and two columns, wherein
in two adjacent pixels, a color setting manner of subpixels in a first row of one pixel is the same as a color setting manner of subpixels in a second row of the other pixel, and a color setting manner of subpixels in a second row of the pixel is the same as a color setting manner of subpixels in a first row of the other pixel.

10. The display panel according to any one of claims 1 to 8, wherein the display panel comprises a plurality of pixels arranged in an array, each pixel comprises four subpixels of different colors, and four subpixels in one pixel are arranged in two rows and two columns, wherein
in two adjacent pixels, a color setting manner of subpixels in a first column of one pixel is the same as a color setting manner of subpixels in a second column of the other pixel, and a color setting manner of subpixels in a second column of the pixel is the same as a color setting manner of subpixels in a first column of the other pixel.

11. The display panel according to claim 9 or 10, wherein the four subpixels of different colors comprise a red subpixel, a blue subpixel, a green subpixel, and a cerulean subpixel.

12. The display panel according to claim 11, wherein each red subpixel comprises, at each light-emitting layer, a first auxiliary layer and a red light-emitting unit that are stacked in the first direction; each green subpixel comprises, at each light-emitting layer, a second auxiliary layer and a green light-emitting unit that are stacked in the first direction; each blue subpixel comprises, at each light-emitting layer, a third auxiliary layer and a blue light-emitting unit that are stacked in the first direction; and each cerulean subpixel comprises one cerulean light-emitting unit at each light-emitting layer.

13. The display panel according to claim 11, wherein the display panel comprises two light-emitting layers;
each red subpixel comprises, at a light-emitting layer that is in the two light-emitting layers and that is close to the cathode, a first auxiliary layer and a red light-emitting unit that are stacked in the first direction, and comprises, at a light-emitting layer that is in the two light-emitting layers and that is close to the anode layer, a red light-emitting unit;
each green subpixel comprises, at the light-emitting layer that is in the two light-emitting layers and that is close to the cathode, a second auxiliary layer and a red light-emitting unit that are stacked in the first direction, and comprises, at the light-emitting layer that is in the two light-emitting layers and that is close to the anode layer, a red light-emitting unit;
each blue subpixel comprises, at the light-emitting layer that is in the two light-emitting layers and that is close to the cathode, a first auxiliary layer and a blue light-emitting unit that are stacked in the first direction, and comprises, at the light-emitting layer that is in the two light-emitting layers and that is close to the anode layer, a blue light-emitting unit; and
each cerulean subpixel comprises one cerulean light-emitting unit at each light-emitting layer.

14. The display panel according to any one of claims 1 to 8, wherein the display panel comprises a plurality of pixels arranged in an array, and each pixel comprises one red subpixel, one blue subpixel, and one or more green subpixels.

15. The display panel according to claim 14, wherein a light-emitting unit of each red subpixel at each light-emitting layer is a red light-emitting unit; a light-emitting unit of each green subpixel at each light-emitting layer is a green light-emitting unit; and a light-emitting unit of each blue subpixel at each light-emitting layer is a blue light-emitting unit.

16. The display panel according to any one of claims 1 to 15, wherein the display panel further comprises a capping layer and an encapsulation layer that are sequentially stacked from the cathode in the first direction.

17. The display panel according to claim 14, wherein the display panel further comprises a capping layer, an encapsulation layer, a color change layer, and a color filter layer that are sequentially stacked from the cathode in the first direction, and light-emitting units of each red subpixel, each green subpixel, and the blue subpixel at each light-emitting layer are all blue light-emitting units;
the red subpixel comprises a red change unit at the color change layer, and comprises a red filter unit at the color filter layer, wherein the red change unit is configured to convert light emitted by a blue light-emitting unit corresponding to the red subpixel into red light for emission, and the red filter unit is configured to filter the red light emitted by the red change unit and then emit red light;
the green subpixel comprises a green change unit at the color change layer, and comprises a green filter unit at the color filter layer, wherein the green change unit is configured to convert light emitted by a blue light-emitting unit corresponding to the green subpixel into green light for emission, and the green filter unit is configured to filter the green light emitted by the green change unit and then emit green light; and
the blue subpixel comprises a blue change unit at the color change layer, and comprises a blue filter unit at the color filter layer, wherein the blue change unit is configured to convert light emitted by a blue light-emitting unit corresponding to the blue subpixel into blue light for emission, and the blue filter unit is configured to filter the blue light emitted by the blue change unit and then emit blue light; or
the blue subpixel comprises a blue filter unit at the color filter layer, and the blue change unit is configured to filter light emitted by a blue light-emitting unit corresponding to the blue subpixel and then emit blue light.

18. The display panel according to claim 14, wherein the display panel further comprises a capping layer, an encapsulation layer, and a color filter layer that are sequentially stacked from the cathode in the first direction, and light-emitting units of each red subpixel, each green subpixel, and each blue subpixel at the plurality of light-emitting layers emit white light as a whole;
the red subpixel comprises a red filter unit at the color filter layer, and the red filter unit is configured to filter the white light emitted by a light-emitting unit corresponding to the red subpixel and then emit red light;
the green subpixel comprises a green filter unit at the color filter layer, and the green filter unit is configured to filter the white light emitted by a light-emitting unit corresponding to the green subpixel and then emit green light; and
the blue subpixel comprises a blue filter unit at the color filter layer, and the blue filter unit is configured to filter the white light emitted by a light-emitting unit corresponding to the blue subpixel and then emit blue light.

19. A display, comprising the display panel according to any one of claims 1 to 18.

20. An electronic device, comprising the display according to claim 19.
